(19) **Europäisches Patentamt / European Patent Office / Office européen des brevets**

(11) **EP 4 141 955 A1**

(12) # DEMANDE DE BREVET EUROPEEN

(43) Date de publication:
**01.03.2023  Bulletin 2023/09**

(21) Numéro de dépôt: **22192886.4**

(22) Date de dépôt: **30.08.2022**

(51) Classification Internationale des Brevets (IPC):
**H01L 29/423** (2006.01)    **H01L 27/10** (2006.01)
**H01L 29/66** (2006.01)    **B82Y 10/00** (2011.01)
**H01L 29/06** (2006.01)

(52) Classification Coopérative des Brevets (CPC):
**H01L 29/66977; H01L 27/10; H01L 29/0692;
H01L 29/423; H01L 29/66439; H01L 29/66984;**
B82Y 10/00; G06N 10/40

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité:  **31.08.2021  FR 2109107**

(71) Demandeurs:
• **Commissariat à l'énergie atomique
et aux énergies alternatives
75015 Paris (FR)**
• **Centre national de la recherche scientifique
75016 Paris (FR)**

(72) Inventeurs:
• **MORTEMOUSQUE, Pierre-André
38054 GRENOBLE CEDEX 09 (FR)**
• **BERTRAND, Benoit
38054 GRENOBLE CEDEX 09 (FR)**
• **JADOT, Baptiste
38054 GRENOBLE CEDEX 09 (FR)**
• **MEUNIER, Tristan
38000 GRENOBLE (FR)**
• **URDAMPILLETA, Matias
38000 GRENOBLE (FR)**
• **VINET, Maud
38054 GRENOBLE CEDEX 09 (FR)**

(74) Mandataire: **Cabinet Camus Lebkiri
25 rue de Maubeuge
75009 Paris (FR)**

(54) **DISPOSITIF QUANTIQUE, PROCÉDÉ DE LECTURE DE L'ÉTAT DE CHARGE, PROCÉDÉ DE DÉTERMINATION D'UN DIAGRAMME DE STABILITÉ ET PROCÉDÉ DE DÉTERMINATION DES CORRÉLATIONS DE SPIN**

(57)    Un aspect de l'invention concerne un dispositif semi-conducteur comprenant une couche d'un matériau semi-conducteur dans laquelle est formée une zone active (ZA); une pluralité de premières grilles (QG1) formant une pluralité de lignes sensiblement parallèles entre elles et recouvrant en partie la zone active ; une pluralité de deuxièmes grilles (QG2) formant une pluralité de colonne, les lignes de la pluralité de lignes croisant les colonnes de la pluralité de colonnes en recouvrant la partie active et étant isolées électriquement de la pluralité de lignes, l'intersection de deux lignes successives avec deux colonnes successives délimitant un îlot (QD) de sorte à obtenir une pluralité d'îlots répartis sur une pluralité de chaînes d'îlots, les chaînes d'îlots étant disposées selon un axe parallèle aux lignes de la pluralité de lignes, chaque chaîne d'îlot comprenant une pluralité d'îlots, une première extrémité matérialisée par une première colonne extrême et une deuxième extrémité (CQDE) matérialisé par une deuxième colonne extrême (QG2E), les îlots étant situés dans la zone active ; au moins une troisième grille (EM), dite grille de mesure, s'étendant selon un axe sensiblement parallèle aux ligne de la pluralité de lignes et dans une direction opposée aux lignes de la pluralité de ligne par rapport à la zone active, l'extrémité de chaque grille de mesure (EM) la plus proche de la deuxième colonne extrême (QG2E) étant située dans la zone active, la ou les troisième grilles étant configurées pour réaliser un ou plusieurs moyens de mesure disposés de sorte à pouvoir mesurer l'état de charge de l'îlot situé au niveau de la deuxième extrémité de chaque chaîne d'îlots (CQDE); une première électrode (CO1) et une deuxième électrode (CO2) situées de part et d'autre de la pluralité de grilles de mesure (ME) dans la zone active et configurées de sorte qu'un courant (I) allant de la première électrode (CO1) à la deuxième électrode (CO2) passe entre la pluralité de grilles de mesure (ME) et la deuxième colonne extrême (CQ2E).

EP 4 141 955 A1

[Fig. 2]

## Description

## DOMAINE TECHNIQUE DE L'INVENTION

Le domaine technique de l'invention est celui de l'information quantique.

La présente invention concerne un dispositif quantique comprenant une matrice de boites quantiques, un procédé de lecture de l'état de charge des boites quantiques d'un tel dispositif, un procédé de détermination du diagramme de stabilité d'un tel dispositif et un procédé de détermination des corrélations de spin d'une pluralité de particules chargées porteuses d'un spin contenu dans un tel dispositif.

## ARRIERE-PLAN TECHNOLOGIQUE DE L'INVENTION

Dans le domaine de l'informatique quantique, il est connu d'utiliser des matrices de boites quantiques afin de réaliser des processeurs quantiques. Plus particulièrement, des particules chargées vont être introduites dans cette matrice de sorte à être confinées dans les boites quantiques. Une pluralité de qubit de spin va ainsi être formée, un qubit de spin représentant le degré de liberté de l'état de spin de la ou des particules chargées dans une ou plusieurs boites quantiques.

Il est également connu, pour mesurer l'état de chaque qubit ainsi formé, de procéder à une étape de conversion spin/charge qui permet de convertir l'état de spin des particules chargées en un état de charge des boites quantiques contenant lesdites particules. Il est alors nécessaire de mesurer cet état de charge afin d'en déduire l'état de spin des particules chargées avant conversion. Pour cela, un moyen de mesure de l'état de charge est en général disposé en regard de chaque boite quantique. Cependant, dans une matrice bidimensionnelle de boîtes quantiques, l'augmentation du nombre de boites quantiques entraine nécessairement l'éloignement progressif des moyens de mesure l'état de charge qui réside alors en périphérie de la matrice. Il en résulte, une perte de signal de mesure pour les boites quantiques centrales de la matrice, ce qui rend l'approche consistant à associer un moyen de mesure à chaque boite quantique difficilement applicable aux matrices de grande taille.

Pour ce type de matrices, il est possible de faire appel à des structures en trois dimensions dans lesquelles les moyens de mesure de l'état de charge sont disposés au-dessus ou au-dessous des boites quantiques. Un exemple d'un tel dispositif est décrit dans le document US 10607993 B2. Or, une telle disposition présente plusieurs inconvénients. Tout d'abord, elle rend la fabrication de telles matrices complexe, notamment en termes d'alignement. En outre, la présence de ces moyens de mesure rend plus difficile l'accès aux boites quantiques, par exemple pour disposer des moyens de manipulation nécessaires aux manipulations quantiques.

Il existe donc un besoin d'un dispositif permettant de s'affranchir des inconvénients énoncés ci-dessous.

## RESUME DE L'INVENTION

L'invention offre une solution aux problèmes évoqués précédemment, en permettant de mutualiser les moyens de mesure de l'état de charge au niveau d'une ou plusieurs lignes de boites quantiques de la matrice de boites quantiques.

Un premier aspect de l'invention concerne un dispositif semiconducteur comprenant :

- une couche d'un matériau semi-conducteur dans laquelle est formée une zone active ;

- une pluralité de premières grilles formant une pluralité de lignes sensiblement parallèles entre elles et recouvrant en partie la zone active ;

- une pluralité de deuxièmes grilles formant une pluralité de colonne, les lignes de la pluralité de lignes croisant les colonnes de la pluralité de colonnes en recouvrant la partie active et étant isolées électriquement de la pluralité de lignes, l'intersection de deux lignes successives avec deux colonnes successives délimitant un îlot de sorte à obtenir une pluralité d'îlots répartis sur une pluralité de chaines d'îlots, les chaînes d'îlots étant disposées selon un axe parallèle aux lignes de la pluralité de lignes, chaque chaîne d'îlot comprenant une pluralité d'îlots, une première extrémité matérialisée par une première colonne extrême et une deuxième extrémité matérialisé par une deuxième colonne extrême, les îlots étant situés dans la zone active ;

- au moins une troisième grille, de préférence une pluralité de troisièmes grilles, dite grille de mesure, s'étendant selon un axe sensiblement parallèle aux lignes de la pluralité de lignes et dans une direction opposée aux lignes de la pluralité de ligne par rapport à la zone active, l'extrémité de chaque grille de mesure la plus proche de la deuxième colonne extrême étant située dans la zone active, la ou les troisième grilles étant configurées pour réaliser un ou plusieurs moyens de mesure disposés de sorte à pouvoir mesurer l'état de charge de l'ilot situé au niveau de la deuxième extrémité de chaque chaine d'ilots ;

- une première électrode et une deuxième électrode situées de part et d'autre de la pluralité de grilles de mesure dans la zone active et configurées de sorte qu'un courant allant de la première électrode à la deuxième électrode passe entre la pluralité de grilles de mesure et la deuxième colonne extrême.

Deux lignes (ou deux colonnes) sont considérées comme étant sensiblement parallèle lorsque l'angle qu'elles forment l'une par rapport à l'autre est inférieur ou égale à 10°, de préférence inférieure ou égal à 5°, voire inférieur ou égale à 1°. Grâce à l'invention, il n'est plus nécessaire de disposer d'un moyen de mesure de l'état de charge pour chaque boite quantique, les moyens de mesure situés à l'extrémité des lignes de boites quantiques pouvant être utilisés pour mesurer l'état de charge de chaque boite quantique de chaque ligne de boites quantiques. Cette disposition permet de simplifier la fabrication d'un tel dispositif et de faciliter l'accès aux boites quantiques, par exemple pour disposer des moyens de manipulation.

Outre les caractéristiques qui viennent d'être évoquées dans le paragraphe précédent, le dispositif selon un premier aspect de l'invention peut présenter une ou plusieurs caractéristiques complémentaires parmi les suivantes, considérées individuellement ou selon toutes les combinaisons techniquement possibles.

Dans un mode de réalisation, le dispositif comprend une pluralité de quatrièmes grilles, chaque quatrième grille de la pluralité de quatrièmes grilles étant située dans un îlot de sorte que chaque îlot de la pluralité d'îlots comprend une quatrième grille de la pluralité de quatrièmes grilles.

Dans un mode de réalisation, le dispositif comprend une pluralité de quatrièmes électrodes, chaque quatrième électrode de la pluralité de quatrièmes électrodes étant située dans la zone active, entre deux grilles de mesure successives de la pluralité de grilles de mesure. De préférence, une quatrième électrode est située entre chaque grille de mesure.

Dans un mode de réalisation, la zone active comprend une pluralité de doigts, une grille de mesure de la pluralité de grilles de mesure étant située entre chaque doigt de la pluralité de doigts, les doigts de la pluralité de doigts étant reliés entre eux par une partie commune, l'extrémité des grilles de mesure la plus proche de la colonne extrême étant située sur ladite partie commune, la première électrode étant situé sur un premier doigt extrême de la pluralité de doigts, la deuxième électrode étant située sur un deuxième doigts extrêmes de la pluralité de doigts, chaque doigt compris entre deux grilles de mesure comprenant une quatrième électrode de la pluralité de quatrièmes électrodes.

Dans un mode de réalisation, chaque doigt possède un indice, les indices étant attribués de manière croissante et continue entre le premier doigt extrême et le deuxième doigt extrême, la longueur des doigts ayant un indice pair étant différentes de la longueur des doigts ayant un indice impair.

Dans un mode de réalisation, la couche de matériau semi-conducteur comprenant la zone active comprend des ouvertures sur la totalité de son épaisseur, lesdites ouverture étant situées sous chaque croisement d'une ligne de la pluralité de ligne avec une colonne de la pluralité de colonnes.

Un deuxième aspect de l'invention concerne un dispositif quantique comprenant une matrice de boites quantiques, chaque boite quantique pouvant recevoir une ou plusieurs particules chargées de sorte à adopter un état de charge supérieur ou égal à zéro, la matrice de boites quantiques comprenant une pluralité de lignes de boites quantiques comprenant chacune une pluralité de boites quantiques, le dispositif comprenant :

- une pluralité de grilles configurées de sorte à permettre un transfert de particules chargées d'une boite quantique donnée de la ligne de boites quantiques à une boite quantique adjacente à la boite quantique donnée, la boite quantique adjacente appartenant également à la ligne de boites quantiques considérée ;

- un ou plusieurs moyens de mesure configurés pour mesurer l'état de charge de chaque boite quantique située à une extrémité de la pluralité de lignes de boites quantiques, dite boite quantique extrême.

Comme pour le dispositif selon un premier aspect de l'invention, grâce au dispositif selon un second aspect de l'invention, il n'est plus nécessaire de disposer d'un moyen de mesure de l'état de charge pour chaque boite quantique, les moyens de mesure situés à l'extrémité des lignes de boites quantiques pouvant être utilisé pour mesurer l'état de charge de chaque boite quantique de chaque ligne de boites quantiques. Cette disposition permet de simplifier la fabrication d'un tel dispositif et de faciliter l'accès aux boites quantiques, par exemple pour disposer des moyens de manipulation.

Un troisième aspect de l'invention concerne un procédé de lecture de l'état de charge des boites quantiques d'au moins une ligne de boites quantiques d'un dispositif selon un premier aspect de l'invention, le procédé comprenant, pour au moins une ligne de boites quantiques, de préférence pour chaque ligne de boites quantiques :

- une première étape de détermination de l'état de charge de la boite quantique extrême de la ligne considérée à l'aide du moyen de mesure de l'état de charge associé à la ligne considérée ;

- une deuxième étape de décharge des particules chargées présentes dans la boite quantique extrême ;

- pour chaque boite quantique de la ligne de boites quantiques considérée et en partant de la boite quantique la plus proche de la boite quantique extrême, une troisième étape de transfert de l'état de charge de la boite quantique considérée vers la boite quantique adjacente à la boite quantique considérée la plus proche de la boite quantique extrême ;
ces trois étapes étant réitérées un nombre de fois égal au nombre de boites quantiques de la ligne de boites quantiques considérée.

Outre les caractéristiques qui viennent d'être évoquées dans le paragraphe précédent, le procédé selon un troisième aspect de l'invention peut présenter une ou plusieurs caractéristiques complémentaires parmi les suivantes, considérées individuellement ou selon toutes les combinaisons techniquement possibles.

Dans un mode de réalisation, les étapes du procédé sont réalisées séquentiellement sur toutes les lignes de boites quantiques du dispositif.

Dans un mode de réalisation, les étapes du procédé sont réalisées simultanément sur toutes les lignes de boites quantiques du dispositif.

Un quatrième aspect de l'invention concerne un procédé de détermination du diagramme de stabilité d'un dispositif quantique selon un premier ou un deuxième aspect de l'invention, chaque boite quantique du dispositif étant séparée des boites quantiques adjacentes par une barrière de potentiel, le procédé comprenant :

- une étape d'introduction d'une pluralité de particules chargées dans le dispositif quantique ;

- une étape d'application d'un jeu de tensions sur la pluralité de grilles ;

- une étape de placement de chacune des boites quantiques dans un régime tel que la barrière de potentiel séparant chaque boite quantique des boites quantiques adjacente est configurée de sorte que la ou les particules chargées contenues dans la boite quantique considérée ne peuvent pas traverser la barrière de potentiel pour se déplacer vers les boites quantiques adjacentes à ladite boite quantique même lorsqu'une telle transition est autorisée d'un point de vue énergétique, dit régime totalement isolé ;

- une étape de mise en oeuvre d'un procédé selon un deuxième aspect de l'invention sur toutes les lignes de boites quantiques du dispositif quantique de sorte à déterminer l'état de charge de chaque boite quantique pour le jeu de tensions appliqués, le régime isolé n'étant levé que lors du transfert de particule chargée d'une boite quantique à la boite quantique adjacente, la levée du régime isolé ne concernant que les boites quantiques concernées par le transfert ;

ces étapes étant répétées pour une pluralité de jeux de tensions de sorte à déterminer le diagramme de stabilité du dispositif quantique.

Un cinquième aspect de l'invention concerne un procédé de détermination des corrélations de spin d'une pluralité de particules chargées porteuses d'un spin contenu dans les boites quantiques d'un dispositif selon un premier ou un deuxième aspect de l'invention, le nombre de boites quantiques du dispositif étant un nombre pair, le procédé comprenant :

- une étape d'initialisation de l'état de charge des boites quantiques du dispositif de sorte que chaque boite quantique contienne une seule particule chargée ;

- une étape de formation d'une pluralité de couple de boites quantiques adjacentes, une boite quantique ne pouvant appartenir qu'à un seul couple de boites quantiques adjacentes ;

- pour chaque couple de boites quantiques adjacentes, une étape de conversion spin/charge de sorte que l'état de charge du couple de boites quantiques est dépendant de l'état de spin initial des particules chargées contenues dans ledit couple ;

- une étape de mise en oeuvre d'un procédé selon un deuxième aspect de l'invention de sorte à déterminer l'état de charge de chaque boite quantique et donc l'état de spin associé à chaque couple de boites quantiques ;

ces étapes étant répétées jusqu'à ce que l'état de spin de l'ensemble des couples de boites quantiques adjacentes qu'il est possible de former ait été déterminé.

Un sixième aspect de l'invention concerne un procédé de fabrication d'un dispositif semiconducteur selon un premier ou un deuxième aspect de l'invention à partir d'un substrat comprenant un empilement semi-conducteur, le procédé comprenant :

- une étape de lithographie de sorte à définir un motif associé à une zone active sur l'empilement semi-conducteur et sur la première couche d'oxyde de silicium lorsqu'une telle couche a été déposée au préalable ;

- Une étape de gravure de l'empilement semi-conducteur selon le motif associé à la zone active définie lors de l'étape de lithographie précédente ;

- Une étape de dépôt d'un premier empilement de grille comprenant une première couche de diélectrique et une deuxième couche d'un matériau conducteur ;

- Une étape de dépôt d'un masque dur sur l'empilement de grille ;

- Une étape de lithographie de sorte à définir un motif associé aux pluralités de premières grilles et de grilles de mesure ;

- Une étape de gravure du masque dur selon le motif défini lors de l'étape de lithographie précédente de sorte à transférer ledit motif dans le masque dur ;

- Une étape de gravure de l'empilement de grille selon le motif défini lors de l'étape de lithographie précédente et transféré au masque dur ;

- Une étape de dépôt d'une deuxième couche diélectrique sur la structure obtenue à l'issue de l'étape précédente ;

- Une étape de dépôt d'une deuxième couche d'un matériau conducteur de sorte à former, avec la deuxième couche diélectrique, un deuxième empilement de grille ;

- Une étape de dépôt d'un masque dur sur le deuxième empilement de grille ;

- Une étape de lithographie de sorte à définir un motif associé à la pluralité de deuxièmes grilles ;

- Une étape de gravure du masque dur selon le motif défini lors de l'étape de lithographie précédente de sorte à transférer ledit motif dans le masque dur ;

- Une étape de gravure du deuxième empilement de grille selon le motif défini lors de l'étape de lithographie précédente et transféré au masque dur.

Outre les caractéristiques qui viennent d'être évoquées dans le paragraphe précédent, le procédé selon un sixième aspect de l'invention peut présenter une ou plusieurs caractéristiques complémentaires parmi les suivantes, considérées individuellement ou selon toutes les combinaisons techniquement possibles.

Dans un mode de réalisation, le substrat est un substrat de type SOI (pour Silicon on Insulator) et l'empilement semi-conducteur comprend une couche d'oxyde enterrée et une première couche de matériau semiconducteur en silicium. De plus, lors de l'étape de gravure selon le motif associé à la zone active définie lors de l'étape de lithographie précédente, la gravure est arrêtée au niveau de la couche d'oxyde enterrée.

Dans un mode de réalisation alternatif, l'empilement semi-conducteur comprend une hétérostructure de semiconducteurs (par ex. Si-SiGe ou GaAs-AlGaAs).

Dans un mode de réalisation, le procédé comprend, après l'étape de gravure selon le motif associé à la zone active, une étape de réalisation de microstructures dans l'empilement semi-conducteur au niveau de la zone active.

Dans un mode de réalisation, l'étape de réalisation de microstructures dans l'empilement semi-conducteur comprend :

- Une étape de dépôt d'un masque dur sur la structure obtenue à l'issue de l'étape précédente, le masque dur comprenant une première couche de masque dur et une deuxième couche de masque dur disposée sur la première couche de masque dur ;

- Une étape de lithographie de sorte à définir un motif associé à une pluralité de lignes parallèles entre elles ;

- Une étape de gravure selon le motif associé à la pluralité de lignes définie lors de l'étape de lithographie précédente, la gravure étant effectuée sur toute l'épaisseur de la deuxième couche de masque dur de sorte à exposer une partie de la première couche de masque dur ;

- Une étape de lithographie de sorte à définir un motif associé à une pluralité de colonnes parallèles entre elles, les colonnes de la pluralité de colonnes croisant les lignes de la pluralité de lignes, une portion de la partie exposée de la première couche de masque dur restant exposée à l'issue de cette étape ;

- Une étape de gravure selon le motif associé à la pluralité de colonnes défini lors de l'étape de lithographie précédente, la gravure étant effectuée sur toute l'épaisseur de la première couche du masque dur de sorte à graver entièrement la portion de la première couche de masque dur restée exposée et ainsi définir une matrice de motifs carrés dans la première couche de masque dur ;

- Une étape de retrait sélectif de la deuxième couche du masque dur ;

- Une étape de gravure de l'empilement semi-conducteur selon les motifs formés dans la première couche du masque dur ;

- Une étape de retrait sélectif de la première couche de masque dur.

Dans un mode de réalisation, les motifs associés microstructure sont intégrés lors de l'étape de lithographie de sorte à définir un motif associé à une zone active et l'étape de réalisation de microstructures est mise en oeuvre lors de l'étape de gravure de la zone active selon ledit motif.

Dans un mode de réalisation, le procédé comprend, avant toutes autres étapes, une étape de dépôt d'une première couche d'oxyde de silicium sur la première couche de semi-conducteur du substrat.

Dans un mode de réalisation, le procédé comprend, à l'issue de l'étape de dépôt du deuxième empilement de grille, une étape de planarisation de l'empilement de grille au niveau de la couche d'un matériau conducteur dudit empilement.

Dans un mode de réalisation, le procédé comprend, à l'issue de la gravure du deuxième empilement de grille, une étape de dépôt conforme d'une couche d'un matériau diélectrique, dit matériau espaceur suivie d'une étape de gravure (type espaceur) de ladite couche de sorte à former des espaceurs au niveau du deuxième empilement de grille.

Dans un mode de réalisation, l'épaisseur de matériau espaceur déposée est choisie de sorte que la zone active située à l'extrémité des grilles de mesure les plus proche des deuxièmes grilles est recouverte par le matériau diélectrique à l'issue de la gravure du matériau espaceur, le procédé comprenant, à l'issue de l'étape de gravure de la couche de matériau espaceur, une étape d'implantation dans les zones non recouvertes par le matériau diélectrique.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

La [Fig. 1] montre un dispositif selon un premier mode de réalisation de l'invention.

La [Fig. 2] montre un dispositif selon un deuxième mode de réalisation de l'invention.

La [Fig. 3] montre un dispositif selon un troisième mode de réalisation de l'invention.

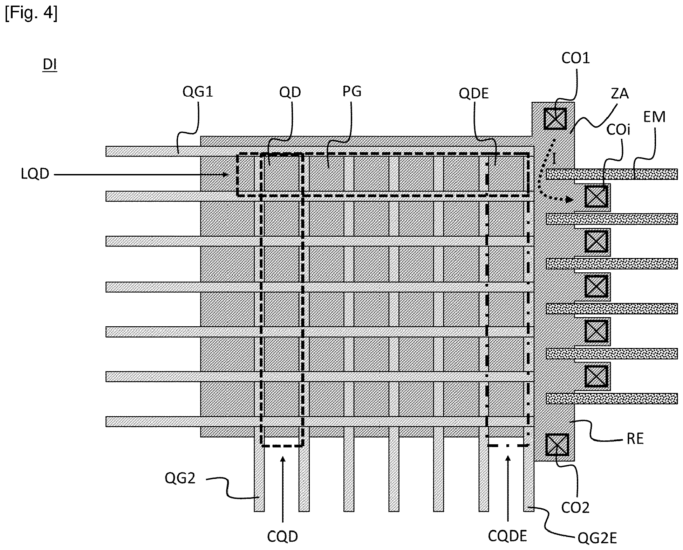

La [Fig. 4] montre un dispositif selon un quatrième mode de réalisation de l'invention.

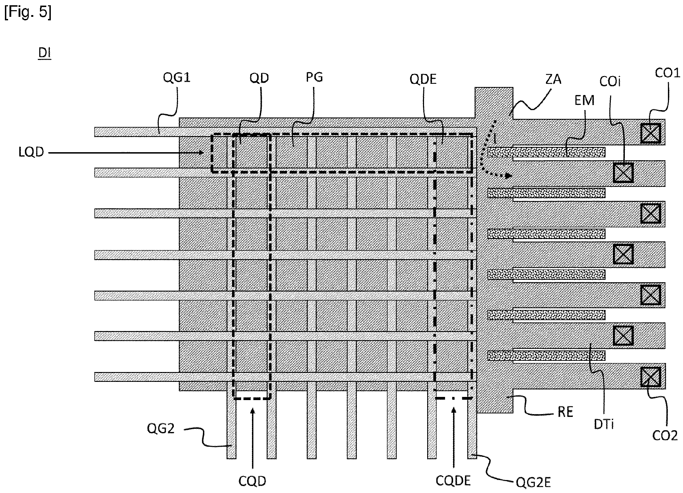

La [Fig. 5] montre un dispositif selon un cinquième mode de réalisation de l'invention.

La [Fig. 6] montre un dispositif selon un sixième mode de réalisation de l'invention.

La [Fig. 7A] montre une configuration dans laquelle les moyens de mesures sont formés par une pluralité de grilles de mesure disposées une ligne de boite quantique sur deux.

La [Fig. 7B] montre une configuration dans laquelle les moyens de mesures sont des transistors à électron unique chacun formé à l'aide de deux grilles de mesures.

La [Fig. 8] montre une représentation schématique d'une boite quantique contenant une particule chargée.

La [Fig. 9] montre une représentation schématique d'un premier mode de lecture de l'état de charge des boites quantiques extrême.

La [Fig. 10] montre une représentation schématique d'un deuxième mode de lecture de l'état de charge des boites quantiques extrême.

La [Fig. 11] montre un ordinogramme d'un procédé selon un deuxième aspect de l'invention.

La [Fig. 12] montre une représentation schématique du transfert de charge d'une boite quantique donnée à une boite quantique adjacente telle que mise en oeuvre dans un procédé selon un deuxième aspect de l'invention.

La [Fig. 13] montre un ordinogramme d'un procédé selon un troisième aspect de l'invention.

La [Fig. 14] montre une représentation schématique du régime isolé mis en oeuvre dans l'invention.

La [Fig. 15] montre un ordinogramme d'un procédé selon un quatrième aspect de l'invention.

Les [Fig. 16A] à [Fig. 16V] illustrent de manière schématique les différentes étapes de fabrication d'un dispositif selon l'invention.

**DESCRIPTION DETAILLEE**

**Dispositifs quantiques**

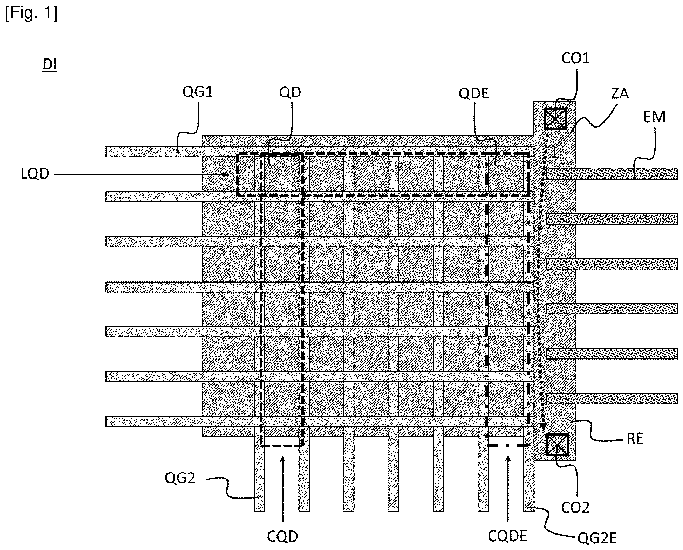

Comme illustré à la [Fig. 1], un premier aspect de l'invention concerne dispositif DI semiconducteur susceptible d'être utilisé comme dispositif quantique.

Ce dispositif comprend une couche d'un matériau semi-conducteur, par exemple du silicium, dans laquelle est formée une zone active ZA.

Ce dispositif DI comprend une pluralité de premières grilles QG1 formant une pluralité de lignes sensiblement parallèles entre elles et recouvrant en partie la zone active ZA. Il comprend également une pluralité de deuxièmes grilles QG2 formant une pluralité de colonnes sensiblement parallèles entre elles, les lignes de la pluralité de lignes croisant, de préférence de manière perpendiculaire, les colonnes de la pluralité de colonnes en recouvrant en partie la zone active ZA et étant isolées électriquement de la pluralité de lignes. La définition d'une grille est ici conforme à la définition dans le domaine, à savoir un élément comprenant une couche d'un matériau conducteur (par exemple du polysilicium dégénéré) et une couche d'un matériau diélectrique (par exemple de l'oxyde de silicium ou de l'hafnie). Comme détaillé dans la suite, ces grilles QG1, QG2 permettent de moduler le champ électrostatique au sein de la zone active ZA de sorte à pouvoir former au sein de cette dernière une pluralité de boites quantiques QD.

Dans un mode de réalisation, la couche de matériau semi-conducteur comprend des ouvertures sur la totalité de son épaisseur, lesdites ouverture étant située sous chaque croisement d'une ligne de la pluralité de lignes avec une colonne de la pluralité de colonnes. La taille de ces microstructures est donc fixée par la taille des grilles de la première et deuxième pluralités de grilles QG1,QG2. Ces microstructures permettent d'améliorer le confinement des éventuelles particules chargées PC présentes dans les îlots lorsque ces derniers sont configurés pour opérer en tant que boites quantiques QD.

De plus, dans le dispositif DI selon l'invention, l'intersection de deux lignes successives avec deux colonnes successives délimite un îlot QD de sorte à obtenir une pluralité d'îlots répartis sur une pluralité de chaines d'îlots LQD. Les chaînes d'îlots LQD ainsi obtenues sont disposées selon un axe parallèle aux lignes de la pluralité de lignes, chaque chaîne d'îlot LQD comprenant une pluralité d'îlots QD. Les boites quantiques QD obtenues par l'application d'un potentiel sur les premières et deuxièmes grilles QG1, QG2 évoquées précédemment seront formées au niveau desdits îlots. En outre, chaque chaîne d'îlots LQD comprend une première extrémité matérialisée par une première colonne extrême et une deuxième extrémité matérialisée par une deuxième colonne extrême QG2E. On notera également que les îlots QD forment aussi une pluralité de colonnes d'îlots CQD et en particulier une colonne extrême d'îlot CQDE le long de la deuxième colonne extrême QG2E.

En outre, le dispositif DI comprend au moins une troisième grille, de préférence une pluralité de troisièmes grilles, dite grille de mesure EM, s'étendant selon un axe sensiblement parallèle aux ligne de la pluralité de lignes et dans une direction opposée aux lignes de la pluralité de lignes par rapport à la zone active ZA, l'extrémité de chaque grille de mesure EM la plus proche de la deuxième colonne extrême QG2E étant située dans la zone active ZA, la ou les troisième grilles EM étant configurées pour réaliser un ou plusieurs moyens de mesure disposés de sorte à pouvoir mesurer l'état de charge de l'ilot situé au niveau de la deuxième extrémité de chaque chaine d'ilots LQD. Autrement dit, la ou les grilles de mesures EM sont configurées pour former un ou plusieurs moyens de mesure, par exemple un ou plusieurs points quantiques ou bien encore un ou plusieurs transistors à électron unique (ou SET pour Single Electron Transistor en anglais). De plus, ce ou ces moyens de mesure sont disposés de sorte que l'état de charge de chaque îlot QD de la colonne extrême QG2E peut être mesuré à l'aide d'un ou plusieurs de ces moyens de mesure.

Enfin, le dispositif DI selon l'invention comprend une première électrode de contact C01 et une deuxième électrode de contact CO2 situées de part est d'autre de la ou des grilles de mesure EM, dans la zone active ZA et en contact avec cette dernière. De plus, ces première et deuxième électrodes CO1,CO2 sont configurées de sorte qu'un courant allant de la première électrode C01 à la deuxième électrode CO2 passe, dans la zone active ZA, entre la ou les grilles de mesure EM et la deuxième colonne extrême QG2E.

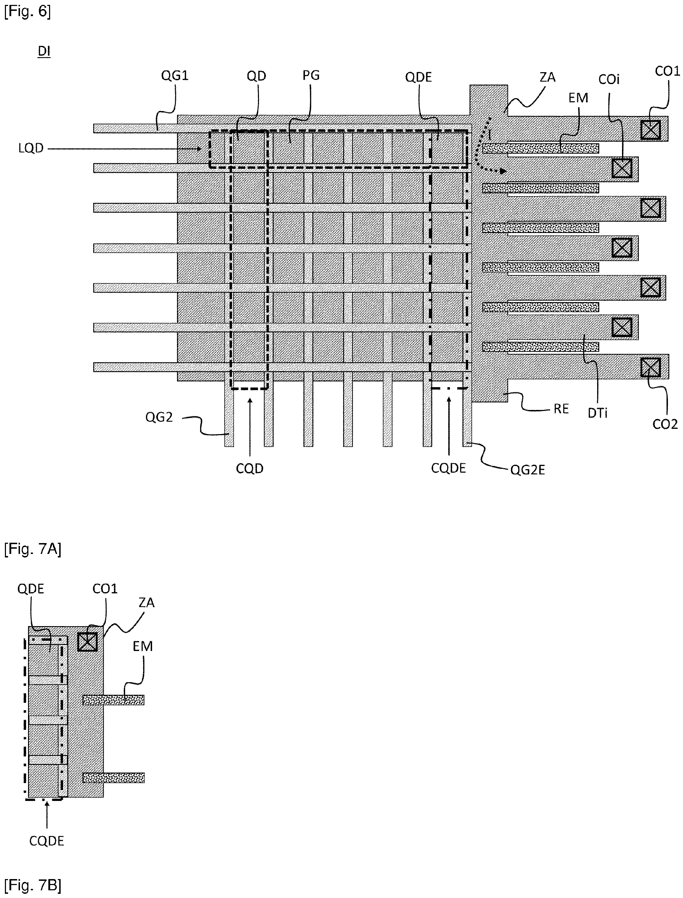

Dans un mode de réalisation illustré aux [Fig. 1] à [Fig.6], une troisième électrode de mesure EM est située en regard de chaque chaine de d'îlot QD de sorte à réaliser, pour chaque chaine d'ilots LQD, un moyen de mesure de l'état de charge de l'îlot situé au niveau de la deuxième extrémité de la chaine d'ilots considérée LQD. Ainsi, dans ce mode de réalisation, un moyen de mesure est formé pour chaque chaine d'ilots LQD.

Cependant, comme mentionné précédemment et illustré aux [Fig. 7A] et [Fig. 7B], il peut en être autrement. Par exemple, dans le mode de réalisation de la [Fig. 7A], un moyen de mesure est formé toutes les deux chaines d'ilots LQD au moyen d'une grille de mesure LQD. Dans l'exemple de la [Fig. 7B], chaque moyen de mesure est un transistor à électron unique formé à l'aide de deux grilles de mesure EM. Dans ce dernier exemple, le dispositif comprend un moyen de mesure pour deux chaines d'ilots LQD.

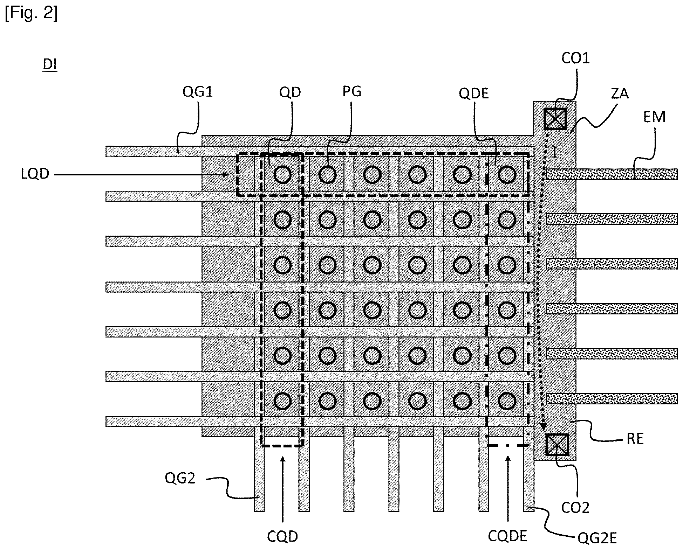

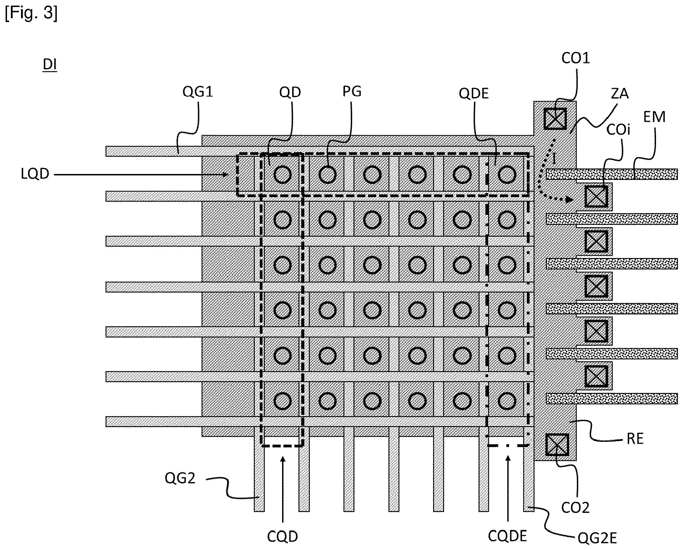

Dans un mode de réalisation illustré à la [Fig. 2] et [Fig. 3], le dispositif DI selon l'invention comprend une pluralité de quatrièmes grilles PG, chaque quatrième grille PG de la pluralité de quatrièmes grilles PG étant située dans un îlot QD de sorte que chaque îlot QD de la pluralité d'îlots QD comprend une quatrième grille PG de la pluralité de quatrièmes grilles PG.

Dans un mode de réalisation illustré de la [Fig. 3] et à la [Fig. 6], le dispositif DI selon l'invention comprend une pluralité de quatrièmes électrodes de contact COi, chaque quatrième électrode de contact COi de la pluralité de quatrièmes électrodes COi étant située dans la zone active ZA, en contact avec cette dernière, entre deux grilles de mesure EM successives de la pluralité de grilles de mesure EM. Dans le mode de réalisation illustré de la [Fig. 3] et à la [Fig. 6], une quatrième électrode de contact COi de la pluralité de quatrièmes électrodes COi est située entre chaque grille de mesure EM. Cependant, il peut en être autrement. Par exemple, lorsque le ou les moyens de mesure de l'état de charge formés par les grilles de mesures EM sont des transistors à électron unique (comme illustré à la [Fig. 7B]), alors chaque électrode de contact COi est séparée de la suivante par deux grilles de mesure EM.

Dans un mode de réalisation, la zone active ZA comprend une pluralité de doigts DTi, une grille de mesure EM de la pluralité de grilles de mesure EM étant située entre chaque doigt DTi de la pluralité de doigts DTi, les doigts DTi de la pluralité de doigts DTi étant reliés entre eux par une partie commune, l'extrémité des grilles de mesure EM la plus proche de la colonne extrême QG2E étant située sur ladite partie commune, la première électrode de contact C01 étant située sur un premier doigt extrême de la pluralité de doigts DTi, la deuxième électrode de contact CO2 étant située sur un deuxième doigts extrêmes de la pluralité de doigts DTi, chaque doigt DTi compris entre deux grilles de mesure EM comprenant une quatrième électrode de contact COi de la pluralité de quatrièmes électrodes de contact COi.

Dans un mode de réalisation, chaque doigt DTi possède un indice, les indices étant attribués de manière croissante et continue entre le premier doigt extrême et le deuxième doigt extrême, la longueur des doigts DTi ayant un indice pair étant différentes de la longueur des doigts DTi ayant un indice impair.

Dans un mode de réalisation, la longueur des doigts DTi est choisie de sorte qu'une partie au moins de chaque doigt DTi n'est pas séparée du doigt DTi suivant ou précédent par une grille de mesure EM. Autrement dit, la partie de chaque grille de mesure EM de la pluralité de grilles de mesure EM en dehors de la partie commune reliant la pluralité de doigts DTi a une longueur inférieure à la longueur des doigts DTi de la pluralité de doigts DTi. Cette configuration permet notamment de faciliter la reprise de contact lors de la réalisation de la première électrode de contact C01, de la deuxième électrode de contact CO2 et de la pluralité de quatrièmes électrodes de contact COi.

Comme détaillé dans la suite, le dispositif DI selon un premier aspect de l'invention qui vient d'être décrit peut être utilisé pour réaliser un dispositif quantique comprenant une matrice de boites quantiques QD.

Un deuxième aspect de l'invention concerne un dispositif DI quantique comprenant une matrice d'ilots, ladite matrice étant définie à l'aide d'une pluralité de grilles. De plus, les îlots de la matrice sont susceptibles d'être opérés en tant que boites quantiques QD lorsqu'un potentiel électrique est appliqué à chaque grille QG1, QG2 de la pluralité de grilles QG1 ,QG2, par exemple à l'aide d'une ou plusieurs sources de tension. Dans la suite de cette description fonctionnelle, ces îlots QD seront désignés pas le terme boite quantique QD afin de souligner la fonction qu'ils sont amenés à remplir.

Dans un mode de réalisation, cette matrice est obtenue à l'aide d'un dispositif DI selon un premier aspect de l'invention, chaque boite quantique QD étant formée au niveau de chaque îlot QD à l'aide des grilles QG1, QG2 délimitant l'îlot en question.

Le dispositif DI quantique selon un deuxième aspect de l'invention est en outre configuré pour permette, au niveau de chaque boite quantique QD, le chargement d'une ou plusieurs particules chargées PC de sorte à adopter un état de charge supérieur ou égal à zéro. Autrement dit, le dispositif DI est configuré de sorte à permettre à une boite quantique QD de contenir zéro, une ou plusieurs particules chargées PC. Par exemple, les particules chargées PC peuvent être des électrons ou bien encore des trous.

Dans un mode de réalisation, le dispositif DI selon un deuxième aspect de l'invention est réalisé à l'aide d'un dispositif DI selon un premier aspect de l'invention et le chargement des boites quantiques QD est effectué par le biais du ou des réservoirs RE de particules chargées PC en jouant sur les potentiels électrostatiques définissant les différentes boites quantiques QD (et donc sur les tensions appliquées à la pluralité de grilles QG1, QG2).

De plus, dans le dispositif DI selon un deuxième aspect de l'invention, la matrice de boites quantiques QD comprend une pluralité de lignes LQD de boites quantiques QD, chaque ligne LQD de boites quantiques QD comprenant une pluralité de boites quantiques QD. De manière similaire, il est possible de définir une pluralité de colonnes CQD de boites quantiques QD, de préférence perpendiculaire aux lignes LQD de boites quantiques QD.

Le dispositif quantique selon un deuxième aspect de l'invention comprend en outre un ou plusieurs moyens de mesure configurés pour mesurer l'état de charge de chaque boite quantique QDE située à une extrémité de la pluralité de lignes LQD de boites quantiques QD, dite boite quantique extrême QDE. Les boites quantiques extrêmes QDE de la pluralité de lignes LQD de boites quantiques QD forment ainsi une colonne CQDE de boites quantiques extrêmes QDE dont l'état de charge peut être mesuré à l'aide du ou des moyens de mesure du dispositif selon un deuxième aspect de l'invention.

Dans un mode de réalisation, le dispositif DI selon un deuxième aspect de l'invention est réalisé à l'aide d'un dispositif DI selon un premier aspect de l'invention et le ou les moyens de mesure sont formés à l'aide de la ou des grilles de mesure EM. On notera qu'un moyen de mesure peut comprendre une seule grille de mesure EM ou bien encore une pluralité de grilles de mesure EM. De préférence, un moyen de mesure est disposé en regard de chaque ligne LQD de boites quantiques QD.

Dans un mode de réalisation, chaque moyen de mesure de l'état de charge comprend une troisième grille EM de détection configurée de sorte à former un électromètre en regard de la boite quantique extrême QDE. Dans les exemples illustrés aux [Fig. 1] à [Fig. 6], la troisième grille EM est parallèle aux grilles QG1 de confinement de la pluralité de premières grilles QG1 de confinement et disposée en regard de la boite quantique extrême QDE. Bien entendu, d'autres configurations peuvent être envisagées afin d'obtenir un électromètre au niveau de chaque boite quantique extrême QDE.

Dans un mode de réalisation illustré aux [Fig. 1] et [Fig. 2], les grilles EM de détection forment une pluralité de grilles EM de détection et le dispositif DI comprend une première électrode de contact C01 et une deuxième électrode de contact CO2 situées de part et d'autre de la pluralité de troisièmes grilles EM, de sorte qu'un courant I circulant de la première électrode de contact C01 à la deuxième électrode de contact CO2 circule entre les boites quantiques extrêmes QDE de chaque ligne LQD de boites quantiques QD et les grilles de mesure EM qui leur sont associées. Dans cette configuration, la mesure de l'état de charge des boites quantiques extrêmes QDE ne peut se faire que ligne LQD par ligne LQD, à partir de la variation du courant I mesuré entre les deux électrodes CO1,CO2 de mesure. En effet, si une lecture simultanée de plusieurs ligne est effectuée, il n'est alors pas possible de déterminer à quelle boite quantique extrême QDE le changement dans le courant I mesuré entre les deux électrodes CO1,CO2 de mesure doit être attribué.

Dans un mode de réalisation alternatif illustré aux [Fig. 3] à [Fig. 6], le dispositif DI comprend une pluralité de quatrièmes de contact COi, chaque grille de mesure EM étant associée à deux électrodes COi situées de part et d'autre de la grille de mesure EM considérée de sorte qu'un courant I circulant entre chacune de ces deux électrodes COi de mesure circule entre la grille de mesure EM et la boite quantique extrême QDE qui lui est associée. Contrairement à la configuration précédente, cette configuration permet la lecture simultanée de l'état de charge de la boite quantique extrême QDE de plusieurs lignes LQD de boites quantiques QD. Cette utilisation simultanée peut par exemple être mise en oeuvre en appliquant une modulation à chaque grille (connu sous le nom de lock-in en anglais) ou bien encore en effectuant de la mesure par réflectométrie par la grille (aussi connue sous le nom de gate-réflectométrie), mesure dans laquelle un circuit résonant est connecté à chacune des grilles. Bien entendu, d'autres techniques peuvent être utilisées comme une mesure de réflectométrie par la source, etc.

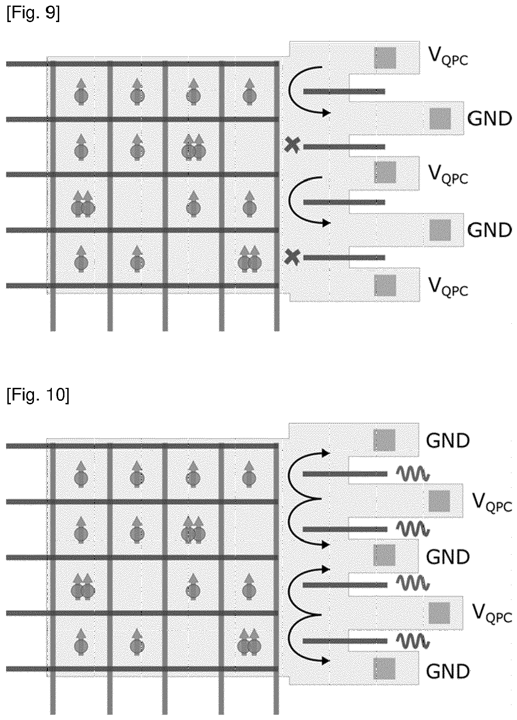

Un premier mode de fonctionnement possible pour la lecture de l'état de charge est illustré à la [Fig. 9]. Dans cette configuration, une grille de mesure EM sur deux est configurée (par l'application d'une tension) pour empêcher de courant de circuler entre ladite grille EM est la colonne extrême QG2E. Un potentiel est ensuite appliqué à la pluralité électrode de contacts COi de sorte qu'un courant passe entre les grilles de mesure EM non bloquantes et la colonne extrême QG2E. Comme illustré sur cette figure, dans un mode de réalisation, les tensions appliquées sur les électrodes de contacts COi correspondent à une alternance de deux tensions, chaque électrode de contact COi se voyant appliquée une tension différente de l'électrode de contact COi précédente ou suivante. En inversant le rôle des grilles de mesure EM, il possible de mesurer l'état de charge de la totalité de boites quantiques extrêmes QDE.

Un deuxième mode de fonctionnement possible pour la lecture de l'état de charge est illustré à la [Fig. 10]. La configuration des tensions appliquées dans ce mode de réalisation est identique au mode de réalisation précédent. Dans un mode de réalisation, une modulation de tension est appliquée sur chaque grille de mesure EM afin de décorréler la composante du signal venant des autres détecteurs (ici formés par chaque grille de mesure EM - cette technique de mesure est parfois appelée mesure lock-in ou bien encore détection synchrone). Ce deuxième mode présente l'avantage de permettre une lecture simultanée de l'ensemble des boites quantiques extrêmes QDE. En revanche, il est nécessaire de prendre en compte l'influence que peuvent avoir les détecteurs les uns sur les autres.

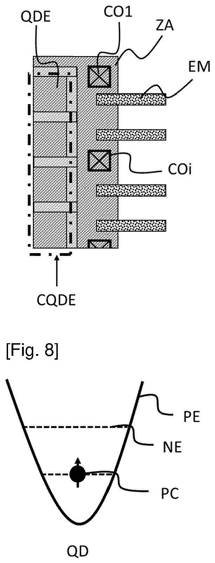

Dans le dispositif quantique DI selon un deuxième aspect de l'invention, la pluralité de grilles QG1,QG2 est également configurée de sorte à permettre un transfert de particules chargées PC d'une boite quantique QD donnée de la ligne de boites quantiques QD à une boite quantique QD adjacente à la boite quantique QD donnée, la boite quantique QD adjacente appartenant également à la ligne LQD de boites quantiques QD considérée. Autrement dit, le transfert de particules chargées PC se fait entre les boites quantiques QD d'une même ligne LQD de boites quantiques QD. Plus particulièrement, comme illustré à la [Fig. 8], cette pluralité de grilles QG1, QG2 de confinement permet de créer une pluralité de barrières de potentiel PE de sorte à définir les boites quantiques QD de la matrice de boites quantiques QD, ces dernières QD permettant de confiner une ou plusieurs particules chargées PC dans un puit de potentiel. Au sein de ce puit de potentiel (et donc d'une boite quantique QD), la ou les particules chargées PC peuvent adopter plusieurs états d'énergie NE chacun associé à un état de spin. Par ailleurs, la pluralité de grilles QG1, QG2 de confinement permet de moduler la barrières de potentiel PE séparant deux boites quantiques QD adjacentes de sorte à isoler ces dernières l'une de l'autre ou bien encore à permettre un transfert de particules chargées PC de l'une à l'autre.

Dans un mode de réalisation, le dispositif DI selon un deuxième aspect de l'invention est réalisé à l'aide d'un dispositif DI selon un premier aspect de l'invention et la pluralité de grilles QG1 ,QG2 de confinement comprend une pluralité de premières grilles QG1 de confinement sensiblement parallèles entres elles formant une pluralité de lignes ; et une pluralité de deuxièmes grilles QG2 de confinement sensiblement parallèles entres elles et croisant, de préférence de manière perpendiculaire, les grilles de confinement de la pluralité de premières grilles QG1 de confinement de sorte à former une pluralité de colonne. Par ailleurs, la zone définie par le croisement de deux lignes consécutives (ou deux premières grilles QG1 de la pluralité de premières grilles QG1) avec deux colonnes consécutives (ou deux deuxièmes grilles QG2 consécutives de la pluralité de deuxièmes grilles QG2) forme une boite quantique QD de sorte à obtenir la matrice de boites quantiques QD. On notera que les boites quantiques QD ainsi formées comprises entre les mêmes grilles QG1 de confinement de la pluralité de premières grilles QG1 de confinement forment une ligne LQD de boites quantiques QD. De manière similaire, les boites quantiques QD ainsi formées comprises entre les mêmes grilles QG2 de confinement de la pluralité de deuxièmes grilles QG2 de confinement forment une colonne CQD de boites quantiques QD.

Dans ce mode de réalisation, il est possible de moduler la barrière PE de potentiel séparant deux boites quantiques QD d'une même ligne LQD de boites quantiques QD à l'aide de la deuxième grille séparant les deux boites quantiques QD. Cette modulation peut être utilisée pour isoler les deux boites quantiques QD l'une de l'autre ou bien encore pour transférer les particules chargées PC de l'une à l'autre. De la même manière, les lignes peuvent être maintenues isolées entre elles à l'aide de la première grille QG1 qui les sépare de sorte à éviter tout transfert de particules chargées d'une boite quantique QD d'une ligne LQD de boites quantiques QD à une autre boite quantique QD d'une ligne LQD de boites quantiques QD adjacente.

Dans un mode de réalisation, le dispositif DI comprend, pour chaque boite quantique QD, une quatrième grille PG configurée de sorte à pouvoir moduler le potentiel électrostatique au sein de la boite quantique QD. Cette quatrième grille PG est connue dans le domaine sous l'appellation anglaise *plunger.* Bien qu'optionnelle, une telle grille PG permet de disposer d'un degré de liberté supplémentaire dans la configuration du puit de potentiel au niveau de chaque boite quantique QD.

Dans un mode de réalisation, le dispositif selon un deuxième aspect de l'invention est réalisé à l'aide d'un dispositif selon un premier aspect de l'invention et cette quatrième électrode PG est située dans la zone définie par le croisement de deux lignes consécutives avec deux colonnes consécutives formant la boite quantique QD considérée et configurée pour moduler le potentiel électrostatique au sein de la boite quantiques QD.

### Lecture de l'état de charge

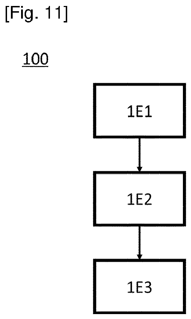

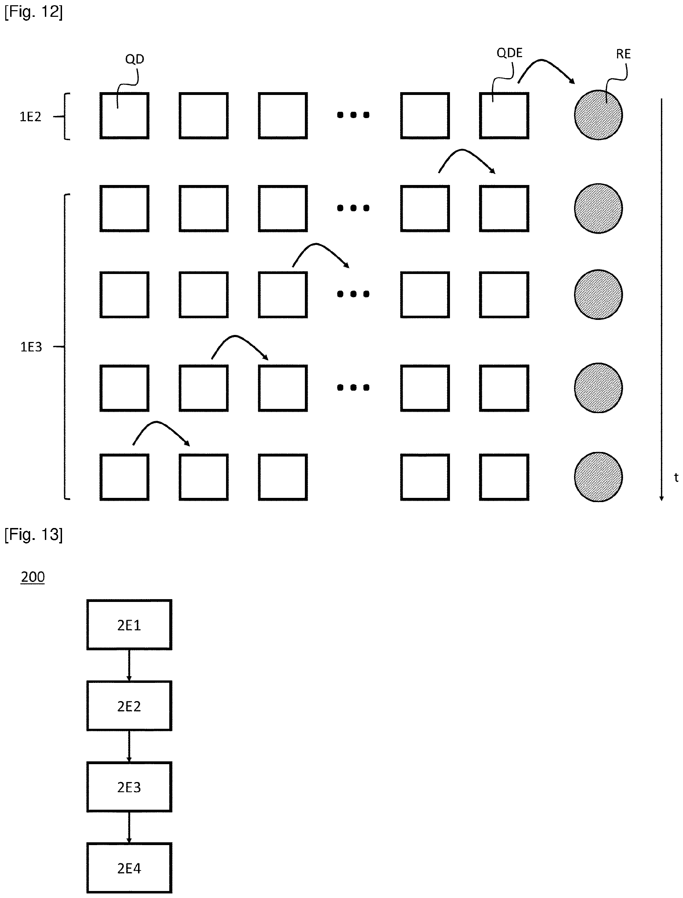

Afin de lire l'état de charge des boites quantiques QD d'un dispositif DI selon un premier aspect ou un deuxième aspect de l'invention, un troisième aspect de l'invention illustré aux [Fig. 11] et [Fig. 12] concerne un procédé 100 de lecture de l'état de charge des boites quantiques QD d'au moins une ligne LQD de boites quantiques QD d'un tel dispositif DI. Le procédé comprend, pour au moins une ligne LQD de boites quantiques QD, de préférence pour toutes les lignes LQD de boites quantiques QD du dispositif DI, les étapes suivantes.

Le procédé 100 comprend tout d'abord une première étape 1E1 de détermination de l'état de charge de la boite quantique extrême QDE de la ligne considérée à l'aide du moyen de mesure EM de l'état de charge associé à la ligne considérée. A l'issue de cette étape, l'état de charge de la boite quantique extrême QDE est connue. On notera qu'un moyen de mesure peut être associé à plusieurs boites quantiques extrêmes QDE. Aussi, un moyen de mesure est dit associé à une boite quantique extrême QDE lorsque le moyen de mesure est susceptible de pouvoir déterminer l'état de charge de la boite quantique extrême QDE considérée.

Une fois cet état de charge connu, il est donc possible de décharger cette dernière afin de rétablir un état de charge égal à zéro. Pour cela, le procédé comprend une deuxième étape 1E2 de décharge des particules chargées PC présentes dans la boite quantique extrême QDE. Les particules chargées PC éventuellement contenues dans la boite quantique extrême QDE sont par exemple déchargées dans des réservoirs auxquels la boite quantique extrême QDE peut être connectée. Cette étape peut par exemple être mise en oeuvre en abaissant la barrière de potentiel PE qui sépare la boite quantique extrême QDE d'un réservoir RE, par exemple en jouant sur la tension appliquée à la deuxième grille QG2 située entre la boite quantique extrême QDE et le réservoir RE en question. Sur les [Fig.1] à [Fig. 6] cette deuxième grille QG2 est la deuxième grille QG2 la plus à droite, c'est-à-dire la deuxième grille extrême QG2E définissant la limite de la matrice de boites quantiques QD au niveau des boites quantiques extrême QDE.

Il est ensuite possible de transférer les particules chargées PC contenues dans la boite quantique adjacente afin de pouvoir en déterminer l'état de charge. Pour cela, le procédé 100 comprend ensuite, pour chaque boite quantique QD de la ligne LQD de boites quantiques QD considérée et en partant de la boite quantique QD la plus proche de la boite quantique QDE extrême, une troisième étape 1E3 de transfert de l'état de charge de la boite quantique QD considérée vers la boite quantique QD adjacente à la boite quantique QD considérée la plus proche de la boite quantique extrême QDE. Autrement dit, le ou les particules chargées PC contenues dans la boite quantique QD considérée sont transférées vers la boite quantique QD adjacente à la boite quantique QD considérée la plus proche de la boite quantique extrême QDE. A l'issue de cette étape 1E3, la ou les particules chargées PC contenues dans la boite quantiques QD d'indice n ont été transférées dans la boite quantique QD d'indice n-1 (ou n est l'indice de la boite quantique QD considérée, l'indice 1 étant attribué à la boite quantique extrême QDE et les indices allant croissant). Cette étape 1E3 peut par exemple être mise en oeuvre en abaissant la barrière de potentiel PE qui sépare la boite quantique QD considérée de la boite quantique QD adjacente à la boite quantique QD considérée la plus proche de la boite quantique extrême QDE, par exemple en jouant sur la tension appliquée à la deuxième grille QG2 séparant les deux boites quantiques QD.

Une illustration de la deuxième étape 1E2 et de la troisième étape 1E3 est proposée à la [Fig. 12] dans laquelle chaque boite quantique QD est représentée par un carré, chaque transfert de particules chargées PC est représenté par une flèche et le réservoir RE dans lequel est déchargée la boite quantique extrême QDE est représenté par un cercle, le temps t s'écoulant de haut en bas.

Afin de déterminer l'état de charge de chaque boite quantique QD de la ligne LQD de boites quantiques QD considérée, les trois étapes 1E1-1E3 qui viennent d'être décrites sont réitérées un nombre de fois égal au nombre de boites quantiques QD de la ligne LQD de boites quantiques QD considérée.

Dans un mode de réalisation, les étapes E1-E3 du procédé 100 sont réalisées séquentiellement sur toutes les lignes LQD de boites quantiques QD du dispositif DI. Par exemple, chaque étape E1-E3 est mise en oeuvre une fois pour chaque ligne LQD de boites quantiques QD, puis le cycle est répété jusqu'à que l'état de charge de l'ensemble des boites quantiques QD du dispositif DI ait été mesuré.

Dans un exemple alternatif, chaque étape E1-E3 est répétée pour une même ligne LQD jusqu'à la détermination de l'état de charge de toutes les boites quantiques QD de la ligne LQD de boites quantiques QD considérée, puis le cycle est répété pour la ligne LQD de boites quantiques QD suivante jusqu'à que l'état de charge de l'ensemble des boites quantiques QD du dispositif DI ait été mesuré. Ce mode de réalisation présente l'avantage d'être simple de mise en oeuvre, mais le temps nécessaire à la détermination de l'état de charge de toutes les boites quantiques QD du dispositif DI croit linéairement avec le nombre boites quantiques QD sur une ligne LQD de boites quantiques QD, mais également avec le nombre de lignes LQD de boites quantiques QD.

Dans un mode de réalisation alternatif, les étapes E1-E3 du procédé 100 sont réalisées simultanément sur toutes les lignes LQD de boites quantiques QD du dispositif DI. Autrement dit, la lecture de l'état de charge des boites quantiques QD se fait en parallèle sur chaque ligne LQD de boite quantique QD. Ce mode de réalisation est plus complexe en mettre en oeuvre, mais il présente l'avantage d'être plus rapide, le temps nécessaire à la détermination de l'état de charge de toutes les boites quantiques QD du dispositif DI dépendant du nombre de boites quantiques QD sur une ligne LQD de boites quantiques QD, mais pas du nombre de lignes LQD de boites quantiques QD.

**Détermination du diagramme de stabilité**

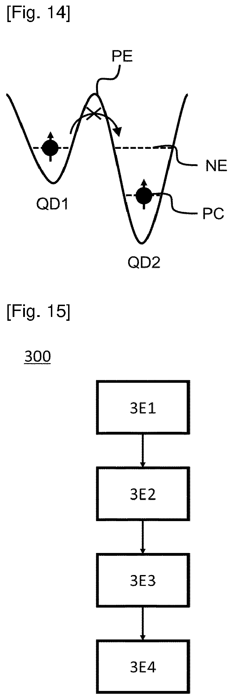

La notion de diagramme de stabilité est bien connue de la personne du domaine et un simple rappel sera donc fait ici. Le diagramme de stabilité caractérise l'état de charge de chaque boite quantique QD d'un système, ici le dispositif DI selon un premier aspect ou un deuxième aspect de l'invention, en fonction de la tension appliquée aux grille QG1, QG2 définissant les boites quantiques QD du dispositif DI. Dans le dispositif DI selon un premier aspect de l'invention ou un deuxième aspect de l'invention, la pluralité de grilles QG1, QG2 de permet de définir les boites quantiques QD du dispositif DI et c'est donc en fonction de la tension appliquée à cette pluralité de grilles QG1, QG2 que l'état de charge de chaque boite quantique QD doit être déterminé. Pour cela, un quatrième aspect de l'invention illustré aux [Fig. 13] et [Fig. 14] concerne un procédé 200 de détermination du diagramme de stabilité d'un dispositif DI quantique selon un premier aspect de l'invention.

Le procédé 200 comprend une étape 2E1 d'introduction d'une pluralité de particules chargées PC dans le dispositif DI quantique. Cette introduction peut se faire par l'intermédiaire d'un ou plusieurs réservoirs RE de particules chargées PC auxquels il est possible de coupler une partie au moins des boites quantiques QD du dispositif DI.

Le procédé 200 comprend ensuite une étape 2E2 d'application d'un jeu de tensions sur la pluralité de grilles QG1, QG2. Le jeu de tension caractérise la tension appliquée sur chaque grille QG1, QG2 de la pluralité de grilles QG1, QG2 (ce jeu de tensions comprend donc une pluralité de tensions, chaque tension de cette pluralité étant appliquée à une grille de la pluralité de grilles QG1, QG2). Comme cela sera détaillé dans la suite, afin d'établir un diagramme de stabilité, il est nécessaire de connaitre l'état de charge de chaque boite quantique QD pour une pluralité de jeux de tensions.

Le procédé 200 comprend également une étape 2E3 de placement de chacune des boites quantiques QD dans un régime dans lequel la barrière de potentiel PE séparant chaque boite quantique QD des boites quantiques QD adjacentes est configurée de sorte que la ou les particules chargées PC contenues dans la boite quantique QD considérée ne peuvent pas traverser la barrière de potentiel PE pour se déplacer vers les boites quantiques QD adjacentes à ladite boite quantique QD même lorsqu'une telle transition est autorisée d'un point de vue énergétique, dit régime totalement isolé.

Pour illustrer la notion de régime totalement isolé au sens de l'invention, un système comprenant deux boites quantiques QD1, QD2 est illustré à la [Fig. 14]. Dans cet exemple, chaque boite quantique QD1, QD2 contient une particule chargée PC. De plus, la barrière de potentiel PE séparant les deux boites quantiques QD1, QD2 est caractérisé par un paramètre $\Gamma$, bien connu de la personne du domaine sous l'appellation anglaise de tunneling rate. Si l'on note $\tau_{proc}$ le temps nécessaire à la mise en oeuvre des étapes du procédé postérieures à l'étape de placement de chacune des boites quantiques QD dans un régime totalement isolé, alors le régime totalement isolé peut être caractérisé par le fait que chaque boite quantique QD est séparée des boites quantiques QD adjacentes par une barrière de potentiel PE dont le paramètre $\Gamma$ vérifie la relation :

$$\Gamma \ll \frac{1}{\tau_{proc}}$$

par exemple :

$$\Gamma < \frac{1}{100 \times \tau_{proc}}$$

Dans cette configuration, comme illustrée à la [Fig. 14], une particule chargée PC ne peut pas passer d'une boite quantique QD1 à l'autre QD2, même si un niveau d'énergie est disponible autorisant un tel transfert.

Le procédé comprend ensuite une étape 2E4 de mise en oeuvre d'un procédé 100 selon un troisième aspect de l'invention sur toutes les lignes LQD de boites quantiques QD du dispositif DI quantique de sorte à déterminer l'état de charge de chaque boite quantique QD pour le jeu de tensions appliqués. Afin de permettre le transfert de charge d'une boite quantique QD à l'autre nécessaire à la mise en oeuvre du procédé 100 selon un troisième aspect de l'invention, le régime isolé n'étant levé que lors du transfert de particules chargées PC d'une boite quantique QD à la boite quantique QD adjacente, la levée du régime isolé ne concernant que les boites quantiques QD concernées par le transfert. Autrement dit, seules les barrières de potentiel PE empêchant le transfert de charge nécessaire à la mise en oeuvre du procédé 100 selon un troisième aspect de l'invention sont concernées par la levée du régime totalement isolée.

Comme déjà mentionné, afin de pouvoir établir le diagramme de stabilité, les étapes 2E1-2E4 qui viennent d'être décrites sont répétées pour une pluralité de jeux de tensions de sorte à déterminer le diagramme de stabilité du dispositif DI quantique.

**Détermination des états de spin des particules chargées**

Lorsqu'un dispositif DI selon un premier aspect de l'invention ou un deuxième aspect de l'invention contient des particules chargées PC porteuses d'un spin, ces dernières vont se coupler entre elles. Afin de déterminer l'état de spin des particules chargées PC, un cinquième aspect de l'invention illustré à la [Fig. 15] concerne un procédé 300 de détermination de l'état de spin (par exemple, entre l'état up et l'état down) d'une pluralité de particules chargées PC porteuses d'un spin contenues dans les boites quantiques QD d'un dispositif DI selon un premier aspect de l'invention ou un deuxième aspect de l'invention.

Le procédé 300 comprend une étape 3E1 d'initialisation de l'état de charge des boites quantiques QD du dispositif DI de sorte que chaque boite quantique QD contient une seule particule chargée PC. Afin de connaitre un jeu de tensions appliqué à la pluralité de grilles EG1, EG2 du dispositif DI compatible avec une telle répartition des particules chargées PC, il est possible de mettre en oeuvre un procédé 200 de détermination du diagramme de stabilité selon un quatrième aspect de l'invention (ou tout autre procédé permettant de déterminer un tel diagramme de stabilité).

Le procédé comprend ensuite une étape 3E2 de formation d'une pluralité de couples de boites quantiques QD adjacentes, une boite quantique QD ne pouvant appartenir qu'à un seul couple de boites quantiques adjacentes QD. Bien entendu, il existe plusieurs configurations permettant de former de tels couples. Cependant, il importe peu de savoir quelle configuration est adoptée ici dans la mesure où, comme cela sera décrit dans la suite, les étapes du procédé sont répétées de sorte à explorer toutes les configurations possibles permettant de former de tels couples.

Le procédé comprend ensuite, pour chaque couple de boites quantiques QD adjacentes, une étape 3E3 de conversion spin/charge de sorte que l'état de charge du couple de boite quantique QD soit dépendant de l'état de spin initial des particules chargées PC contenues dans ledit couple.

Le procédé comprend également une étape 3E4 de mise en oeuvre d'un procédé 100 selon un deuxième aspect de l'invention de sorte à déterminer l'état de charge de chaque boite quantique QD. A partir de l'état de charge de chaque boite quantique QD, il est possible de déterminer l'état de charge de chaque couple de boites quantiques QD. Or, l'étape de conversion spin/charge permet de remonter à l'état de spin des particules chargées dudit couple. Aussi, lors de cet étape 3E4, l'état de spin associé à chaque couple de boites quantiques QD est également déterminé.

Comme déjà mentionné précédemment, ces étapes 3E1-3E4 sont répétées jusqu'à ce que l'état de spin de l'ensemble des couples de boites quantiques QD adjacentes qu'il est possible de former soit déterminé.

**Fabrication d'un dispositif selon l'invention**

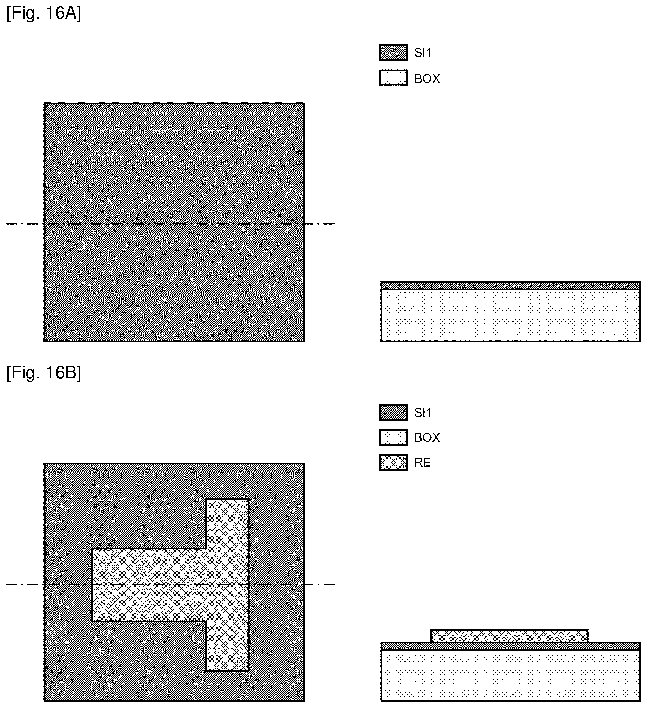

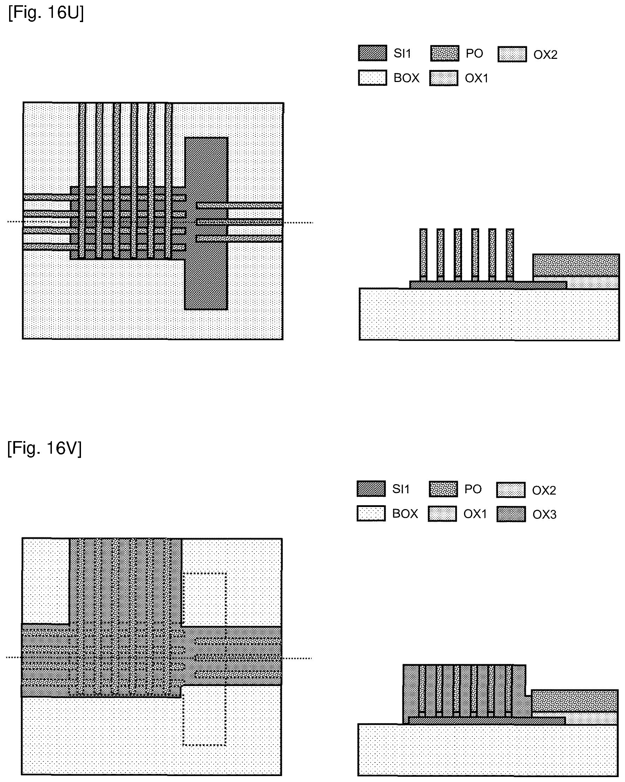

Un sixième aspect de l'invention concerne un procédé de fabrication d'un dispositif DI semiconducteur selon l'invention. Ce procédé est illustré aux [Fig. 16A] à [Fig. 16V] sur lesquelles l'illustration de gauche est une vue de dessus et l'illustration de droite est une vue en coupe selon la droite en pointillé figurant sur l'illustration de gauche.

Le procédé de fabrication selon l'invention est mis en oeuvre à l'aide d'un substrat comprenant un empilement semi-conducteur.

Dans un mode de réalisation illustré à la [Fig. 16A], le substrat est un substrat de type SOI et l'empilement semi-conducteur comprend une première couche d'un matériau semi-conducteur SI1 et une couche d'oxyde enterrée BOX disposé sous la première couche de matériau semi-conducteur SI1 (en silicium).

Cependant, l'empilement semi-conducteur (voire le substrat) peut également être de type Si bulk ou comprendre une hétérostructure de semiconducteurs (par exemple Si/SiGe, GaAs/AlGaAs, Ge/SiGe).

Autrement dit, l'empilement semi-conducteur est choisi de sorte à obtenir un confinement des particules chargées PC selon l'axe perpendiculaire à la surface du substrat. Ce confinement est réalisé dans la couche de silicium SI1 à l'aide de la couche d'oxyde enterrée BOX dans le cas d'un substrat de type SOI et par de l'ingénierie de bande bien connu de la personne du domaine dans le cas d'un empilement semi-conducteur comprenant une hétérostructure (par exemple dans la couche de silicium pour une hétérostructure Si/SiGe). Dans la suite, l'invention sera illustrée dans le cas d'un empilement semi-conducteur relatif à un substrat de type SOI, mais les enseignements décrits plus loin sont aisément transférables à un empilement semi-conducteur comprenant une hétérostructure.

Dans un mode de réalisation, l'épaisseur de la couche d'oxyde enterrée BOX est comprise entre 20 nm et 200nm, de préférence égale à 145 nm. Dans un mode de réalisation, l'épaisseur de la première couche de silicium est comprise entre 10 nm et 20 nm, de préférence égale à 16 nm.

Dans un mode de réalisation, le procédé comprend une étape de dépôt (non illustrée) d'une première couche d'oxyde de silicium sur l'empilement semi-conducteur, c'est-à-dire, dans l'exemple choisi, sur la première couche de matériau semi-conducteur SI1 du substrat, la troisième couche d'oxyde de silicium ayant une épaisseur inférieure à 10 nm, de préférence inférieure à 5 nm, voire inférieure à 2.5 nm. Cette étape est optionnelle, mais elle permet d'éviter le contact direct entre la première couche de matériau semi-conducteur SI1 du substrat et la résine RE utilisée pour l'étape de lithographie à suivre. Dans la suite des illustrations, on se placera dans le cas où une telle étape n'a pas été mise en oeuvre.

Comme illustré à la [Fig. 16B], le procédé comprend ensuite une étape de lithographie de sorte à définir, à l'aide d'une résine RE, un motif associé à une zone active ZA sur l'empilement semi-conducteur, c'est-à-dire, dans l'exemple choisi, sur la première couche de matériau semi-conducteur SI1 du substrat et sur la première couche d'oxyde de silicium lorsqu'une telle couche a été déposée au préalable. Cette zone active ZA viendra constituer la zone active du dispositif DI semi-conducteur selon l'invention. Cette dernière ZA peut donc adopter les différentes géométries qui ont été introduites lors de la description du dispositif DI selon un premier aspect de l'invention.

Dans un mode de réalisation, le motif comprend, au niveau de la zone active ZA, des structures permettant, lors de la gravure à suivre, de réaliser des ouvertures au sein de la zone active ZA. Dans un mode de réalisation, ces structures ont une taille caractéristique comprise entre 40 nm et 60nm, le pas desdites structures étant quant à lui compris entre 80 nm à 120nm.

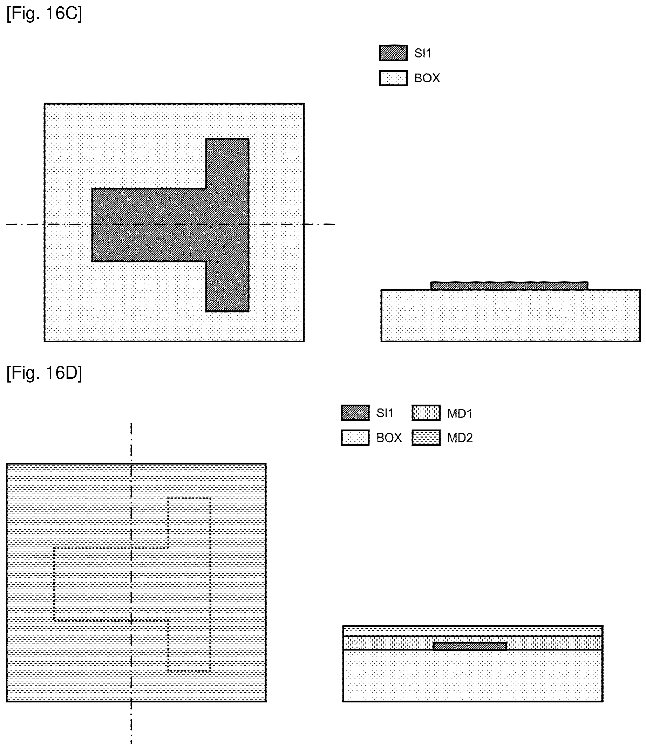

Le procédé 400 comprend ensuite une étape de gravure de l'empilement semi-conducteur selon le motif associé à la zone active ZA définie lors de l'étape de lithographie précédente. Dans un mode de réalisation, lorsque l'empilement semi-conducteur comprend une couche d'oxyde enterré, la gravure est arrêtée au niveau de la couche d'oxyde enterré BOX du substrat. Le résultat obtenu après retrait de la résine RE est illustré à la [Fig. 16C].

Dans un mode de réalisation alternatif, les structures au niveau de la zone active ZA sont réalisées à l'aide des étapes suivantes.

Comme illustré à la [Fig. 16D], la réalisation des structures comprend une étape de dépôt d'un masque dur sur la structure obtenue à l'issue de l'étape précédente, le masque dur comprenant une première couche MD1 de masque dur (par exemple du nitrure de silicium) et une deuxième couche MD2 de masque dur (par exemple de l'oxyde de silicium) disposée sur la première couche MD1 de masque dur.

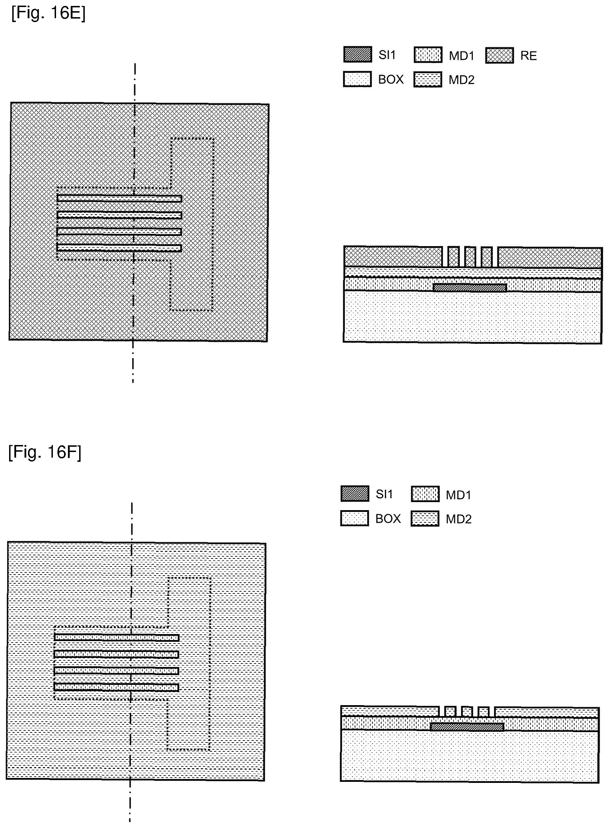

Comme illustré à la [Fig. 16E], la réalisation des structures comprend ensuite une étape de lithographie de sorte à définir, à l'aide d'une résine RE, un motif formant une pluralité de lignes parallèles entre elles.

La réalisation des structures comprend ensuite une étape de gravure selon le motif associé à la pluralité de lignes définie lors de l'étape de lithographie précédente, la gravure étant effectuée sur toute l'épaisseur de la deuxième couche MD2 de masque dur de sorte à exposer une partie de la première couche MD1 de masque dur. La structure obtenue après retrait de la résine RE est illustrée à la [Fig. 16F].

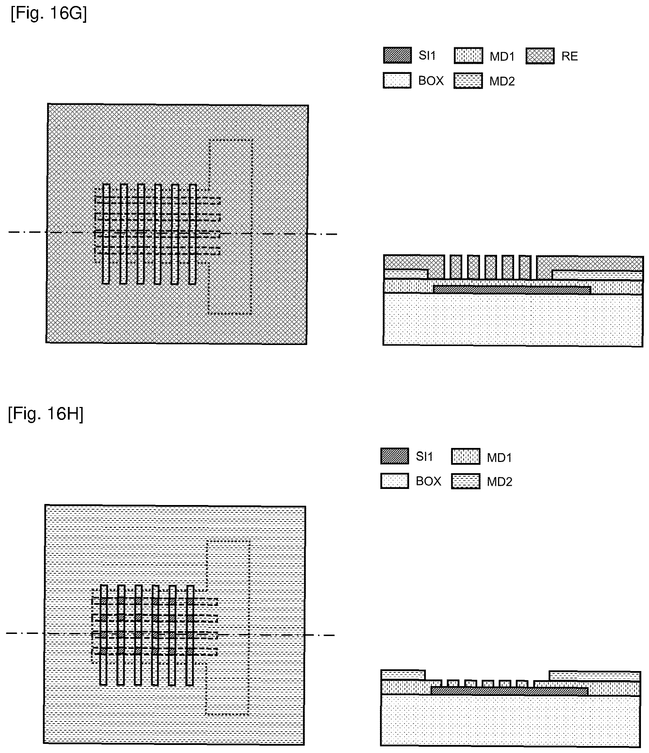

Comme illustré à la [Fig. 16G], la réalisation des structures comprend également une étape de lithographie de sorte à définir, à l'aide d'une résine RE, un motif formant une pluralité de colonnes parallèles entre elles, les colonnes de la pluralité de colonnes croisant, de préférence de manière perpendiculaire, les lignes de la pluralité de lignes. Comme illustré à la [Fig. 16G], une portion de la partie exposée de la première couche MD1 de masque dur reste exposée à l'issue de cette étape. Cette portion prend la forme d'une matrice de carrés, chaque carré étant situé au croisement d'une ligne et d'une colonne des motifs précédemment introduits.

La réalisation des structures comprend ensuite une étape de gravure selon le motif associé à la pluralité de colonnes défini lors de l'étape de lithographie précédente, la gravure étant effectuée sur toute l'épaisseur de la première couche MD1 du masque dur. La structure obtenue après retrait de la résine RE est illustré à la [Fig. 16H]. On notera que, à l'issue de cette étape, la portion restée exposée a été gravée et apparait sous la forme d'une matrice de carrés en matériau semi-conducteur sur l'illustration de gauche de la [Fig. 16H].

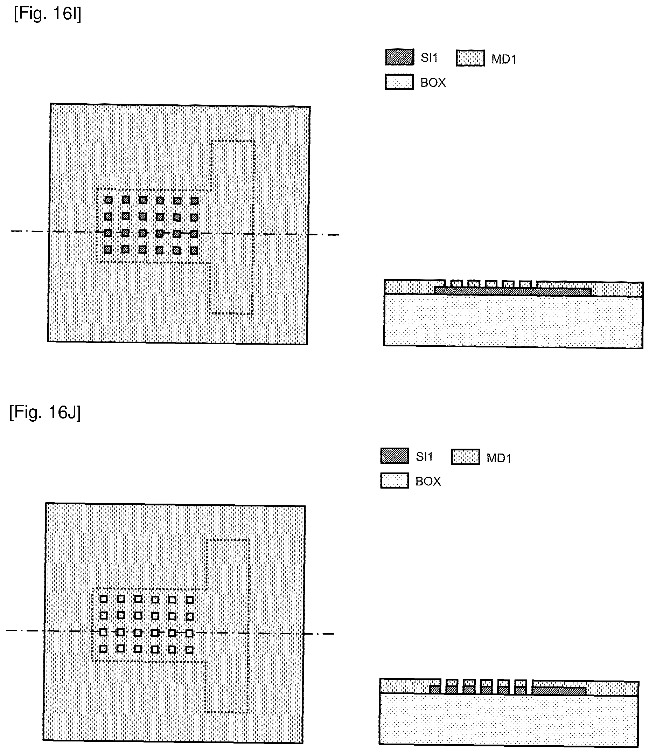

Comme illustré à la [Fig. 16I], la réalisation des structures comprend ensuite une étape de retrait sélectif de la deuxième couche MD2 du masque dur, puis, comme illustré à la [Fig. 16J], une étape de gravure de l'empilement semi-conducteur, c'est-à-dire, dans l'exemple choisi, de la première couche de matériau semi-conducteur SI1 du substrat selon les motifs formés dans la première couche MD1 du masque dur.

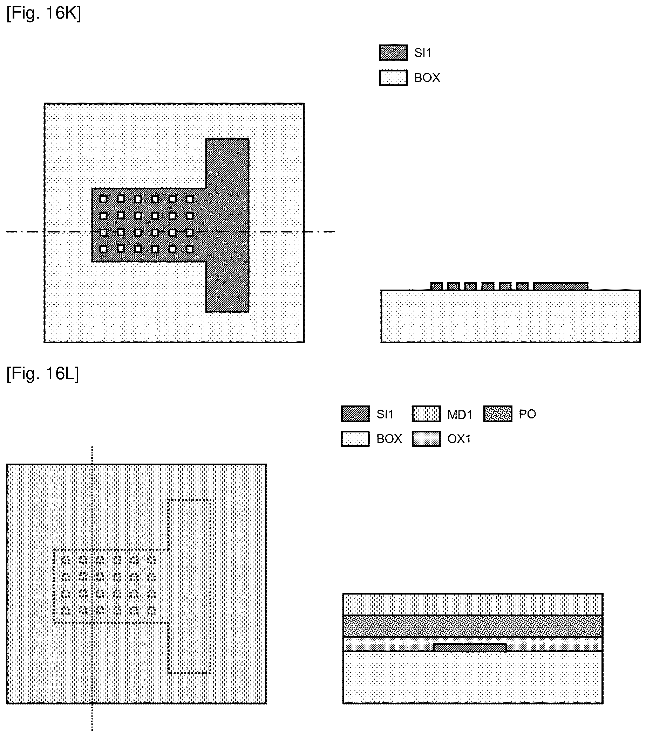

Comme illustré à la [Fig. 16K], la réalisation des structures comprend enfin une étape de retrait sélectif de la première couche MD1 de masque dur. A l'issue de cette étape, une matrice d'ouvertures de forme carré est présente sur l'empilement semi-conducteur, c'est-à-dire, dans l'exemple choisi, sur la première couche de matériau semi-conducteur SI1 du substrat, ces ouvertures laissant apparaitre la couche d'oxyde BOX du substrat lorsque l'empilement comprend une telle couche. Comme déjà mentionné, ces ouvertures améliorent le confinement électrostatique au sein du dispositif DI selon l'invention.

Comme déjà mentionné, la réalisation de structure selon l'une des variantes qui viennent d'être décrites est optionnelle.

Le procédé 400 comprend ensuite une étape de dépôt d'un premier empilement de grille comprenant une première couche de diélectrique OX1, par exemple de l'oxyde de silicium et une deuxième couche d'un matériau conducteur PO, par exemple une couche de polysilicium dégénéré.

Comme illustré à la [Fig. 16L], cette étape est suivie d'une étape de dépôt d'un masque dur MD sur l'empilement de grille.

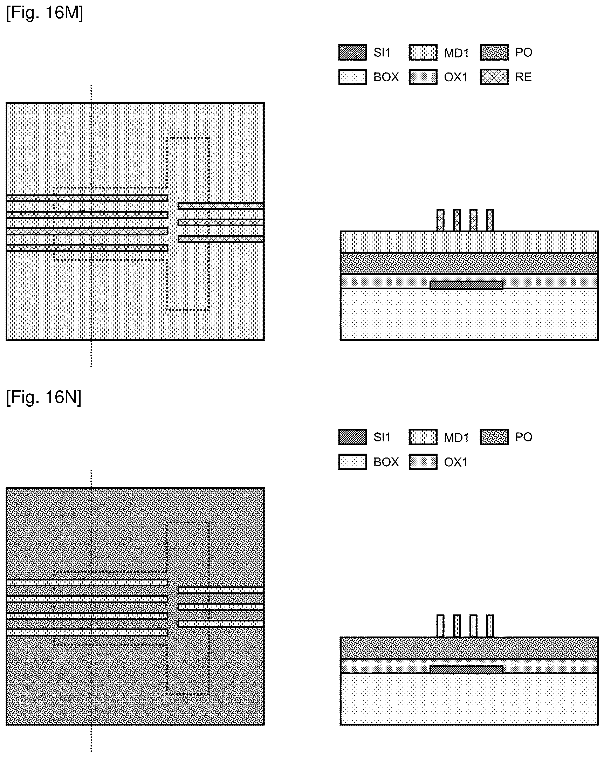

Comme illustré à la [Fig. 16M], le procédé comprend ensuite une étape de lithographie de sorte à définir, par exemple à l'aide d'une résine RE, un motif associé aux premières grilles QG1 et aux grilles de mesure EM. Dans un mode de réalisation, la largeur des grilles est comprise entre 80 nm et 120 nm, par exemple égale à 100 nm.

Le procédé comprend aussi une étape de gravure du masque dur MD1 selon le motif défini lors de l'étape de lithographie précédente de sorte à transférer ledit motif dans le masque dur MD1. La structure obtenue après retrait de la résine RE est illustrée à la [Fig. 16N].

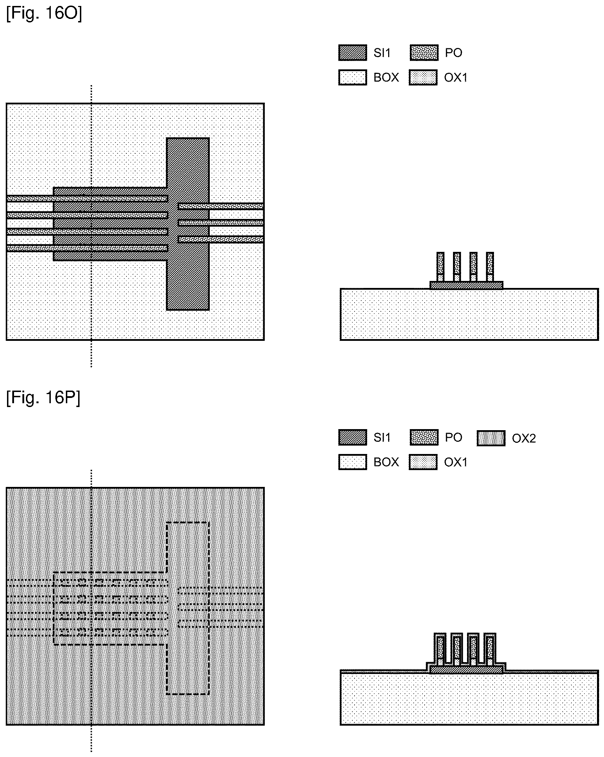

Comme illustré à la [Fig. 16O], le procédé comprend ensuite une étape de gravure de l'empilement de grille selon le motif défini lors de l'étape de lithographie précédente et transféré au masque dur MD1. A l'issue de cette étape, la pluralité de première grilles QG1 et de grilles de mesure EM ont été formées.

Comme illustré à la [Fig. 16P], le procédé comprend ensuite une étape de dépôt conforme d'une deuxième couche diélectrique OX2 sur la structure obtenue à l'issue de l'étape précédente. Dans un mode de réalisation, cette deuxième couche de diélectrique OX2 est dans le même matériau que la première couche de diélectrique OX1 du premier empilement de grille, mais il peut bien entendu en être autrement. Dans un mode de réalisation, l'épaisseur déposée est comprise entre 2 nm et 10nm, de préférence égale à 5nm.

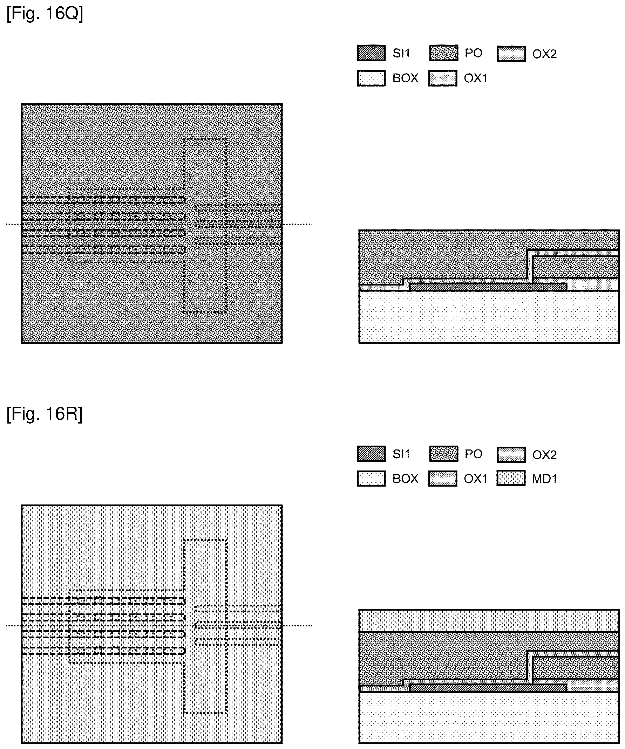

Comme illustré à la [Fig. 16Q], le procédé comprend ensuite une étape de dépôt d'une deuxième couche d'un matériau conducteur PO, par exemple du polysilicium dégénéré de sorte à constituer, avec la deuxième couche de diélectrique déposée précédemment, un deuxième empilement de grille. Les matériaux utilisés dans le deuxième empilement de grille peuvent être différents ou, au moins en partie, identique aux matériaux utilisés dans le premier empilement de grille.

Dans un mode de réalisation, cette étape est suivie d'un une étape de planarisation du deuxième empilement de grille au niveau de la deuxième couche d'un matériau conducteur dudit empilement. Bien que facultative, cette étape permet de faciliter l'étape de gravure à suivre.

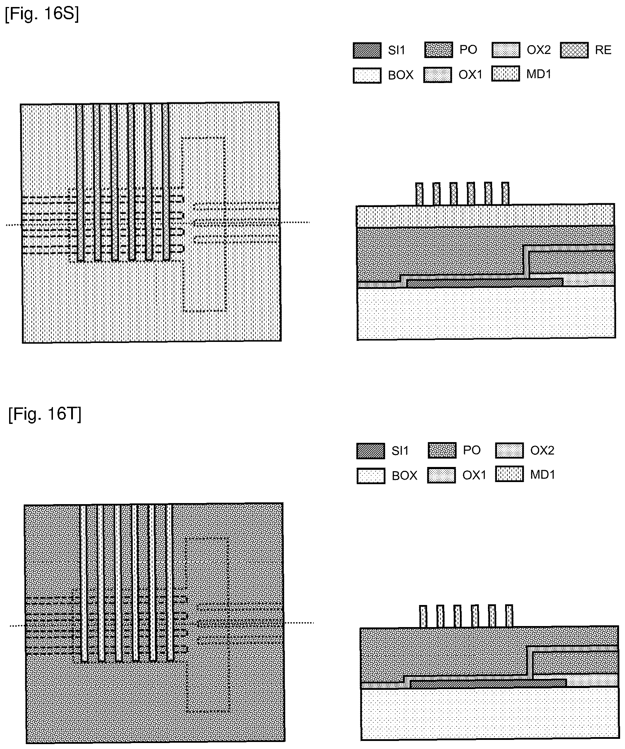

Comme illustré à la [Fig. 16R], le procédé comprend ensuite une étape de dépôt d'un masque dur MD1 sur le deuxième empilement de grille, puis, comme illustré à la [Fig. 16S], une étape de lithographie de sorte à définir, par exemple à l'aide d'une résine RE, un motif associé à la pluralité de deuxièmes grilles QG2.

Le procédé comprend ensuite une étape de gravure du masque dur MD1 selon le motif défini lors de l'étape de lithographie précédente de sorte à transférer ledit motif dans le masque dur MD1. La structure obtenue à l'issue de cette étape après retrait de la résine est illustrée à la [Fig. 16T].

Comme illustré à la [Fig. 16U], le procédé comprend ensuite une étape de gravure de l'empilement de grille selon le motif défini lors de l'étape de lithographie précédente et transféré au masque dur. A l'issue de cette étape, la pluralité de deuxièmes grilles QG2 a été formée.

A l'issue de ces étapes, une première pluralité de grilles QG1, une deuxième pluralité de grilles QG2 et une pluralité de grilles de mesure EM ont été obtenues, ces dernières étant disposée relativement à la zone active ZA conformément à la description qui a été faite du dispositif semi-conducteur selon l'invention.

Dans un mode de réalisation, afin de réaliser des espaceurs pour les pluralités de grilles évoquées précédemment, le procédé de fabrication selon l'invention comprend une étape de dépôt conforme d'une couche d'un matériau diélectrique OX3, dit matériau espaceur, suivie d'une étape de gravure (dite de type espaceur). La structure obtenue à l'issue de ces deux étapes est illustrée à la [Fig. 16V].

Dans un mode de réalisation, l'épaisseur de matériau espaceur déposée est choisie de sorte que la partie de la zone active ZA située à l'extrémité des grilles de mesure EM les plus proche des deuxièmes grilles QG2 est recouverte par le matériau diélectrique à l'issue de l'étape de gravure du matériau diélectrique OX3. Ainsi, il est alors possible de réaliser un dopage des réservoirs RE de charge sur les parties de zone active non recouvertes par le matériau diélectrique des espaceurs. Pour cela, le procédé comprend, à l'issue de l'étape de gravure de la couche de matériau diélectrique OX3 des espaceurs, une étape d'implantation dans les zones non recouverte par le matériau diélectrique OX3.

Dans une mode de réalisation alternatif, lorsque la géométrie des espaceurs ne permet pas la mise en oeuvre d'un dopage tel que décrit précédemment, le procédé de fabrication selon l'invention comprend, à l'issue de l'étape de gravure du deuxième empilement de grille ou à l'issue de la gravure de la couche de matériau diélectrique relative aux espaceur :

- une étape de lithographie de sorte à définir un motif de zones à implanter afin de former des réservoirs de particules chargées dans la deuxième couche de matériau conducteur, de part est d'autre des grilles de mesure ;

- une étape d'implantation dans les zones définies lors de l'étape de lithographie précédente.

Dans un mode de réalisation, l'étape d'implantation précédente est précédée d'une étape d'épitaxie ou bien remplacée par une étape d'épitaxie avec incorporation de dopants. Il est utile de noter que l'épitaxie au niveau des grilles (par exemple, dans le cas de grille comprenant du polysilicium) est empêchée par la présence de résidus de masque dur MD1.

Dans un mode de réalisation, le procédé comprend également une étape de retrait des résidus de masque dur, avantageusement par retrait sélectif. Il comprend ensuite une étape de siliciuration du sommet des pluralités de première et deuxième grilles QG1,QG2 et de la pluralité de grilles de mesure EM ainsi que des réservoirs RE (formée par les zone implantés) de particules de chargées.

Par la suite, une repise de contact selon les procédures standard peut être mise en oeuvre afin de contacter les grilles QG1,QG2,EM et les réservoirs RE de particules chargées PC.

## Revendications

1.  Dispositif (DI) semiconducteur comprenant :

    - une couche d'un matériau semi-conducteur dans laquelle est formée une zone active (ZA) ;
    - une pluralité de premières grilles (QG1) formant une pluralité de lignes sensiblement parallèles entre elles et recouvrant en partie la zone active (ZA) ;
    - une pluralité de deuxièmes grilles (QG2) formant une pluralité de colonne, les lignes de la pluralité de lignes croisant les colonnes de la pluralité de colonnes en recouvrant en partie la zone active (ZA) et étant isolées électriquement de la pluralité de lignes, l'intersection de deux lignes successives avec deux colonnes successives délimitant un îlot (QD) de sorte à obtenir une pluralité d'îlots (QD) répartis sur une pluralité de chaines d'îlots (LQD), les chaînes d'îlots (LQD) étant disposées selon un axe parallèle aux lignes de la pluralité de lignes, chaque chaîne d'îlot (LQD) comprenant une pluralité d'îlots (QD), une première extrémité matérialisée par une première colonne extrême et une deuxième extrémité matérialisé par une deuxième colonne extrême (QG2E) ;
    - au moins une troisième grille, dite grille de mesure (EM), s'étendant selon un axe sensiblement parallèle aux ligne de la pluralité de lignes et dans une direction opposée aux lignes de la pluralité de lignes par rapport à la zone active (ZA), l'extrémité de chaque grille de mesure (EM) la plus proche de la deuxième colonne extrême (QG2E) étant située dans la zone active (ZA), la ou les troisièmes grilles (EM) étant configurées pour réaliser un ou plusieurs moyens de mesure disposés de sorte à pouvoir mesurer l'état de charge de l'ilot situé au niveau de la deuxième extrémité de chaque chaine d'ilots (LQD) ;
    - une première électrode (CO1) et une deuxième électrode (CO2) situées de part et d'autre de la ou des grilles de mesure (EM) dans la zone active (ZA) et configurées de sorte qu'un courant allant de la première électrode (C01) à la deuxième électrode (CO2) passe entre la ou les grilles de mesure (EM) et la deuxième colonne extrême (QG2E).

2.  Dispositif (DI) selon la revendication précédente dans lequel une troisième électrode de mesure (EM) est située en regard de chaque chaine de d'îlot (QD).

3.  Dispositif (DI) selon l'une des revendications précédentes comprenant une pluralité de quatrièmes grilles (PG), chaque quatrième grille (PG) de la pluralité de quatrièmes grilles (PG) étant située dans un îlot (QD) de sorte que chaque îlot (QD) de la pluralité d'îlots (QD) comprend une quatrième grille (PG) de la pluralité de quatrièmes grilles (PG).

4.  Dispositif (DI) selon l'une des deux revendications précédentes comprenant une pluralité de grilles de mesure (EM) et une pluralité de quatrièmes électrodes (COi), chaque quatrième électrode (COi) de la pluralité de quatrièmes électrodes (COi) étant située dans la zone active (ZA), entre deux grilles de mesure (EM) successives de la pluralité de grilles de mesure (EM).

5.  Dispositif (DI) selon la revendication précédente dans lequel la zone active (ZA) comprend une pluralité de doigts (DTi), une grille de mesure (EM) de la pluralité de grilles de mesure (EM) étant située entre chaque doigt (DTi) de la pluralité de doigt (DTi), les doigts (DTi) de la pluralité de doigts (DTi) étant reliés entre eux par une partie commune, l'extrémité des grilles de mesure (EM) la plus proche de la colonne extrême (QG2E) étant située sur ladite partie commune, la première électrode (C01) étant située sur un premier doigt extrême de la pluralité de doigts (DTi), la deuxième électrode (CO2) étant située sur un deuxième doigt extrême de la pluralité de doigts (DTi), chaque doigt (DTi) compris entre deux grilles de mesure (EM) comprenant une quatrième électrode (COi) de la pluralité de quatrièmes électrodes (COi).

6.  Dispositif selon la revendication précédente dans lequel chaque doigt (DTi) possède un indice, les indices étant attribués de manière croissante et continue entre le premier doigt extrême et le deuxième doigt extrême, la longueur des doigts (DTi) ayant un indice pair étant différente de la longueur des doigts (DTi) ayant un indice impair.

7.  Dispositif selon l'une des revendications précédentes dans lequel la couche de matériau semi-conducteur comprenant la zone active (ZA) comprend des ouvertures sur la totalité de son épaisseur, lesdites ouvertures étant situées sous chaque croisement d'une ligne de la pluralité de ligne avec une colonne de la pluralité de colonnes.

8. Procédé (100) de lecture de l'état de charge des boites quantiques (QD) d'au moins une ligne (LQD) de boites quantiques (QD) d'un dispositif (DI) selon l'une des revendications précédentes, chaque îlot (QD) du dispositif (DI) étant configuré pour former une boite quantique (QD), chaque chaine (LQD) d'îlots (QD) formant ainsi une ligne de boite quantique (LQD) et chaque îlot (QD) de la deuxième colonne extrême (QG2E) formant une boite quantique extrême (QDE), le procédé (100) comprenant, pour au moins une ligne (LQD) de boites quantiques (QD) :

- une première étape (1E1) de détermination de l'état de charge de la boite quantique extrême (QDE) de la ligne (LQD) considérée à l'aide du moyen de mesure (EM) de l'état de charge associé à la ligne (LQD) considérée ;
- une deuxième étape (1E2) de décharge des particules chargées (PC) présentes dans la boite quantique extrême (QDE) ;
- pour chaque boite quantique (QD) de la ligne (LQD) de boites quantiques (QD) considérée et en partant de la boite quantique (QD) la plus proche de la boite quantique (QDE) extrême, une troisième étape (1E3) de transfert de l'état de charge de la boite quantique (QD) considérée vers la boite quantique (QD) adjacente à la boite quantique (QD) considérée la plus proche de la boite quantique extrême (QDE) ;

ces trois étapes (1E1-1E3) étant réitérées un nombre de fois égal au nombre de boites quantiques (QD) de la ligne (LQD) de boites quantiques (QD) considérée.

9. Procédé (100) selon la revendication précédente dans lequel les étapes (E1-E3) du procédé (100) sont réalisées séquentiellement sur toutes les lignes (LQD) de boites quantiques (QD) du dispositif (DI).

10. Procédé (100) selon la revendication 8 dans lequel les étapes (E1-E3) du procédé (100) sont réalisées simultanément sur toutes les lignes (LQD) de boites quantiques (QD) du dispositif (DI).

11. Procédé (200) de détermination du diagramme de stabilité d'un dispositif (DI) quantique selon l'une des revendications 1 à 7, chaque îlot (QD) du dispositif (DI) étant configuré pour former une boite quantique (QD), chaque chaine (LQD) d'îlots (QD) formant ainsi une ligne de boite quantique (LQD) et chaque îlot (QD) de la deuxième colonne extrême (QG2E) formant une boite quantique extrême (QDE), chaque boite quantique (QD) étant séparée des boites quantiques (QD) adjacentes par une barrière de potentiel (PE), le procédé comprenant :

- une étape (2E1) d'introduction d'une pluralité de particules chargées (PC) dans le dispositif (DI) quantique ;
- une étape (2E2) d'application d'un jeu de tensions sur la pluralité de grilles (QG1, QG2);
- une étape (2E3) de placement de chacune des boites quantiques (QD) dans un régime tel que la barrière de potentiel (PE) séparant chaque boite quantique (QD) des boites quantiques (QD) adjacente est configurée de sorte que la ou les particules chargées (PC) contenues dans la boite quantique (QD) considérée ne peuvent pas traverser la barrière de potentiel (PE) pour se déplacer vers les boites quantiques (QD) adjacentes à ladite boite quantique (QD) même lorsqu'une telle transition est autorisée d'un point de vue énergétique, dit régime totalement isolé ;
- une étape (2E4) de mise en oeuvre d'un procédé (100) selon l'une des trois revendications précédentes sur toutes les lignes (LQD) de boites quantiques (QD) du dispositif (DI) quantique de sorte à déterminer l'état de charge de chaque boite quantique (QD) pour le jeu de tensions appliqués, le régime isolé n'étant levé que lors du transfert de particules chargées (PC) d'une boite quantique (QD) à la boite quantique (QD) adjacente, la levée du régime isolé ne concernant que les boites quantiques (QD) concernées par le transfert ;

ces étapes (2E1-2E4) étant répétées pour une pluralité de jeux de tensions de sorte à déterminer le diagramme de stabilité du dispositif (DI) quantique.

12. Procédé (300) de détermination de l'état de spin d'une pluralité de particules chargées porteuses d'un spin contenu dans les boites quantiques (QD) d'un dispositif (DI) selon l'une des revendications 1 à 7, chaque îlot (QD) du dispositif (DI) étant configuré pour former une boite quantique (QD), chaque chaine (LQD) d'îlots (QD) formant ainsi une ligne de boite quantique (LQD) et chaque îlot (QD) de la deuxième colonne extrême (QG2E) formant une boite quantique extrême (QDE), le procédé comprenant :

- une étape (3E1) d'initialisation de l'état de charge des boites quantiques (QD) de sorte que chaque boite quantique (QD) contienne une seule particule chargée (PC) ;
- une étape (3E2) de formation d'une pluralité de couples de boites quantiques (QD) adjacentes, une boite quantique (QD) ne pouvant appartenir qu'à un seul couple de boites quantiques adjacentes (QD) ;
- pour chaque couple de boites quantiques (QD)

adjacentes, une étape (3E3) de conversion spin/charge de sorte que l'état de charge du couple de boites quantiques (QD) est dépendant de l'état de spin initial des particules chargées (PC) contenues dans ledit couple ;

- une étape (3E4) de mise en oeuvre d'un procédé (100) selon l'une des revendications 7 à 9 de sorte à déterminer l'état de charge de chaque boite quantique (QD) et donc l'état de spin associé à chaque couple de boites quantiques (QD) ;

ces étapes (3E1-3E4) étant répétées jusqu'à ce que l'état de spin de l'ensemble des couples de boites quantiques (QD) adjacentes qu'il est possible de former ait été déterminé.

13. Procédé de fabrication d'un dispositif (DI) semiconducteur selon l'une des revendications 1 à 5 à partir d'un substrat comprenant un empilement semi-conducteur, le procédé comprenant :

   - une étape de lithographie de sorte à définir un motif associé à une zone active (ZA) sur l'empilement semi-conducteur et sur la couche de diélectrique présente sur l'empilement semi-conducteur (SI1) lorsqu'une telle couche a été déposée au préalable ;
   - Une étape de gravure de l'empilement semi-conducteur selon le motif associé à la zone active (ZA) définie lors de l'étape de lithographie précédente ;
   - Une étape de dépôt d'un premier empilement de grille comprenant une deuxième couche de diélectrique (OX1) et une première couche d'un matériau conducteur (PO) ;
   - Une étape de dépôt d'un masque dur (MD1) sur l'empilement de grille ;
   - Une étape de lithographie de sorte à définir un motif associé aux pluralités de premières grilles (OG1) et de grilles de mesure (EM) ;
   - Une étape de gravure du masque dur (MD1) selon le motif défini lors de l'étape de lithographie précédente de sorte à transférer ledit motif dans le masque dur (MD1) ;
   - Une étape de gravure de l'empilement de grille selon le motif défini lors de l'étape de lithographie précédente et transféré au masque dur (MD1) ;
   - Une étape de dépôt d'une troisième couche de diélectrique (OX2) sur la structure obtenue à l'issue de l'étape précédente ;
   - Une étape de dépôt d'une deuxième couche d'un matériau conducteur (PO) sur la troisième couche de diélectrique (OX2) de sorte à former avec cette dernière un deuxième empilement de grille ;
   - Une étape de dépôt d'un masque dur (MD1)

sur le deuxième empilement de grille ;
   - Une étape de lithographie de sorte à définir un motif associé à la pluralité de deuxièmes grilles (QG2) ;
   - Une étape de gravure du masque dur (MD1) selon le motif défini lors de l'étape de lithographie précédente de sorte à transférer ledit motif dans le masque dur (MD1) ;
   - Une étape de gravure du deuxième empilement de grille selon le motif défini lors de l'étape de lithographie précédente et transféré au masque dur (MD1).

14. Procédé selon la revendication précédente comprenant, à l'issue de l'étape de gravure selon le motif associé à la zone active, une étape de réalisation de microstructures dans l'empilement semi-conducteur (SI1) au niveau de la zone active (ZA).

15. Procédé selon la revendication précédente dans lequel l'étape de réalisation de microstructures dans l'empilement semi-conducteur comprend :

   - Une étape de dépôt d'un masque dur sur la structure obtenue à l'issue de l'étape précédente, le masque dur comprenant une première couche de masque dur (MD1) et une deuxième couche de masque dur (MD2) disposée sur la première couche (MD1) de masque dur ;
   - Une étape de lithographie de sorte à définir un motif associé à une pluralité de lignes parallèles entre elles ;
   - Une étape de gravure selon le motif associé à la pluralité de lignes définie lors de l'étape de lithographie précédente, la gravure étant effectuée sur toute l'épaisseur de la deuxième couche (MD2) de masque dur de sorte à exposer une partie de la première couche (MD1) de masque dur ;
   - Une étape de lithographie de sorte à définir un motif associé à une pluralité de colonnes parallèles entre elles, les colonnes de la pluralité de colonnes croisant les lignes de la pluralité de lignes, une portion de la partie exposée de la première couche (MD1) de masque dur restant exposée à l'issue de cette étape ;
   - Une étape de gravure selon le motif associé à la pluralité de colonnes défini lors de l'étape de lithographie précédente, la gravure étant effectuée sur toute l'épaisseur de la première couche (MD1) du masque dur de sorte à graver entièrement la portion de la première couche (MD1 ) de masque dur restée exposée et ainsi définir une matrice de motifs parallélogrammes dans la première couche (MD1) de masque dur ;
   - Une étape de retrait sélectif de la deuxième couche (MD2) du masque dur ;
   - Une étape de gravure de l'empilement semi-conducteur selon les motifs formés dans la première couche (MD1) du masque dur ;
- Une étape de retrait sélectif de la première couche de masque dur (MD1).

16. Procédé selon la revendication 15 dans lequel les motifs associés microstructure sont intégrés lors de l'étape de lithographie de sorte à définir un motif associé à une zone active (ZA) et l'étape de réalisation de microstructures est mise en oeuvre lors de l'étape de gravure de la zone active selon ledit motif.

17. Procédé selon l'une des revendications 13 à 16 comprenant, avant toutes autres étapes, une étape de dépôt d'une première couche d'oxyde de silicium sur l'empilement semi-conducteur.

18. Procédé selon l'une des revendications 13 à 17 précédentes comprenant, à l'issue de l'étape de dépôt du deuxième empilement de grille, une étape de planarisation de l'empilement de grille au niveau de la couche d'un matériau conducteur dudit empilement.

[Fig. 1]

[Fig. 2]

[Fig. 3]

[Fig. 4]

[Fig. 5]

DI

[Fig. 6]

DI

[Fig. 7A]

[Fig. 7B]

QDE CO1 ZA

EM

COi

CQDE

[Fig. 8]

PE

NE

PC

QD

[Fig. 9]

[Fig. 10]

[Fig. 11]

<u>100</u>

```
┌─────────────┐
│     1E1     │
└─────────────┘
       │
       ▼
┌─────────────┐
│     1E2     │
└─────────────┘
       │
       ▼
┌─────────────┐
│     1E3     │
└─────────────┘
```

[Fig. 12]

[Fig. 13]

200

[Fig. 14]

[Fig. 15]

300

[Fig. 16A]

[Fig. 16B]

[Fig. 16C]

SI1

BOX

[Fig. 16D]

SI1    MD1

BOX    MD2

[Fig. 16E]

SI1  MD1  RE
BOX  MD2

[Fig. 16F]

SI1  MD1
BOX  MD2

EP 4 141 955 A1

EP 4 141 955 A1

[Fig. 16G]

[Fig. 16H]

34

[Fig. 16I]

[Fig. 16J]

[Fig. 16K]

[Fig. 16L]

[Fig. 16M]

SI1   MD1   PO
BOX   OX1   RE

[Fig. 16N]

SI1   MD1   PO
BOX   OX1

[Fig. 16O]

SI1    PO
BOX   OX1

[Fig. 16P]

SI1    PO    OX2
BOX   OX1

[Fig. 16Q]

SI1  PO  OX2

BOX  OX1

[Fig. 16R]

SI1  PO  OX2

BOX  OX1  MD1

[Fig. 16S]

SI1  PO  OX2  RE
BOX  OX1  MD1

[Fig. 16T]

SI1  PO  OX2
BOX  OX1  MD1

[Fig. 16U]

SI1    PO    OX2
BOX    OX1

[Fig. 16V]

SI1    PO    OX2
BOX    OX1    OX3

Europäisches
Patentamt

European
Patent Office

Office européen
des brevets

# RAPPORT DE RECHERCHE EUROPEENNE

Numéro de la demande

EP 22 19 2886

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 9 842 921 B2 (WISCONSIN ALUMNI RES FOUND [US]) 12 décembre 2017 (2017-12-12) * Figures 1, 2, 10a-c, 18-20 et texte correspondant. * ----- | 1-18 | INV. H01L29/423 H01L27/10 H01L29/66 |
| A | EP 2 075 745 A1 (HITACHI LTD [JP]) 1 juillet 2009 (2009-07-01) * Figures 1, 2, 11, 12, 18 et texte correspondant. * ----- | 1-18 | ADD. B82Y10/00 H01L29/06 |
| A,D | US 10 607 993 B2 (COMMISSARIAT ENERGIE ATOMIQUE [FR]; CENTRE NAT RECH SCIENT [FR]) 31 mars 2020 (2020-03-31) * Figures 1-4 et texte correspondant. * ----- | 1-18 | |
| A | US 10 978 578 B2 (UNIV PRINCETON [US]) 13 avril 2021 (2021-04-13) * Figures 3-5 et texte correspondant. * ----- | 1-18 | |
| A | CN 103 105 724 A (TAIWAN MEMORY COMPANY) 15 mai 2013 (2013-05-15) * Figures 2, 5 et texte correspondant. * ----- | 1-18 | DOMAINES TECHNIQUES RECHERCHES (IPC) |
| A | LEE N ET AL: "Enhancing electrostatic coupling in silicon quantum dot array by dual gate oxide thickness for large-scale integration", APPLIED PHYSICS LETTERS, AMERICAN INSTITUTE OF PHYSICS, 2 HUNTINGTON QUADRANGLE, MELVILLE, NY 11747, vol. 116, no. 16, 23 avril 2020 (2020-04-23), XP012246323, ISSN: 0003-6951, DOI: 10.1063/1.5141522 [extrait le 2020-04-23] * le document en entier * ----- | 1-18 | H01L B82Y |

Le présent rapport a été établi pour toutes les revendications

| Lieu de la recherche | Date d'achèvement de la recherche | Examinateur |
|---|---|---|
| Munich | 10 janvier 2023 | Dauw, Xavier |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
....................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 22 19 2886

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-01-2023

| Document brevet cité au rapport de recherche | Date de publication | Membre(s) de la famille de brevet(s) | Date de publication |
|---|---|---|---|
| US 9842921 B2 | 12-12-2017 | AUCUN | |
| EP 2075745 A1 | 01-07-2009 | AUCUN | |
| US 10607993 B2 | 31-03-2020 | CN 108878519 A | 23-11-2018 |
| | | EP 3401848 A1 | 14-11-2018 |
| | | FR 3066297 A1 | 16-11-2018 |
| | | US 2018331108 A1 | 15-11-2018 |
| US 10978578 B2 | 13-04-2021 | US 2017317203 A1 | 02-11-2017 |
| | | US 2020027972 A1 | 23-01-2020 |
| | | WO 2017190030 A1 | 02-11-2017 |
| CN 103105724 A | 15-05-2013 | AUCUN | |

EPO FORM P0460

Pour tout renseignement concernant cette annexe : voir Journal Officiel de l'Office européen des brevets, No.12/82

**EP 4 141 955 A1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 10607993 B2